(19) Europäisches Patentamt / European Patent Office / Office européen des brevets

(11) **EP 3 400 110 B1**

(12) **EUROPÄISCHE PATENTSCHRIFT**

(45) Veröffentlichungstag und Bekanntmachung des Hinweises auf die Patenterteilung:
**07.04.2021 Patentblatt 2021/14**

(21) Anmeldenummer: **16819470.2**

(22) Anmeldetag: **12.12.2016**

(51) Int Cl.:
**B23K 26/36** *(2014.01)* **B28D 1/22** *(2006.01)*

(86) Internationale Anmeldenummer:
**PCT/EP2016/080667**

(87) Internationale Veröffentlichungsnummer:
**WO 2017/118533 (13.07.2017 Gazette 2017/28)**

(54) **VERFAHREN UND VORRICHTUNG ZUM PLANAREN ERZEUGEN VON MODIFIKATIONEN IN FESTKÖRPERN**

METHOD AND DEVICE FOR PRODUCING PLANAR MODIFICATIONS IN SOLID BODIES

PROCÉDÉ ET DISPOSITIF DE GÉNÉRATION PLANAIRE DE MODIFICATIONS DANS DES CORPS SOLIDES

(84) Benannte Vertragsstaaten:
**AL AT BE BG CH CY CZ DE DK EE ES FI FR GB GR HR HU IE IS IT LI LT LU LV MC MK MT NL NO PL PT RO RS SE SI SK SM TR**

(30) Priorität: **05.01.2016 DE 102016000051**

(43) Veröffentlichungstag der Anmeldung:
**14.11.2018 Patentblatt 2018/46**

(73) Patentinhaber: **Siltectra GmbH**
**01099 Dresden (DE)**

(72) Erfinder:
• **RIESKE, Ralf**
**01099 Dresden (DE)**
• **BEYER, Christian**
**09599 Freiberg (DE)**
• **GÜNTHER, Christoph**
**09126 Chemnitz (DE)**
• **RICHTER, Jan**
**01277 Dresden (DE)**
• **SWOBODA, Marko**
**01097 Dresden (DE)**

(74) Vertreter: **Westphal, Mussgnug Patentanwälte & Partner mbB**
**Werinherstraße 79**
**81541 München (DE)**

(56) Entgegenhaltungen:
EP-A1- 1 338 371 EP-A1- 2 687 317
WO-A1-2015/036140 DE-A1-102010 020 183

**Beschreibung**

Die vorliegende Erfindung liegt auf dem Gebiet der Festkörperscheibenherstellung bzw. Waferherstellung.

Gemäß Anspruch 1 bezieht sich die vorliegende Erfindung auf ein Verfahren zur Erzeugung von Modifikationen in einem Festkörper und gemäß Anspruch 11 auf eine Vorrichtung zum Erzeugen von Modifikationen in einem Festkörper.

EP1338371 A1 offenbart den Oberbegriff der Ansprüche 1 und 11.

Mit dem Cold Split Verfahren (vgl. WO2010072675) exisitiert ein neuartiges Verfahren zum Abtrennen von Halbleiterscheiben (Wafern) aus Ingots bzw. Boules (Halbleiterbarren je nach Herstellverfahren - Ziehen aus der Schmelze oder Abscheiden aus der Gasphase). Beim Cold Split wird durch die Stirnfläche des Halbleiteringots eine Laserschadschicht als Sollbruchstelle in gewünschter Tiefe verbracht. Es wird ein proprietärer Polymerfilm mit guter Haftung aufgebracht und stark abgekühlt. Aufgrund der mechanischen Spannungen durch stark unterschiedliche thermische Ausdehnungskoeffizienten wird eine Halbleiterscheibe vom Ingot oder Boule abgelöst.

Es stellt eine Alternative für das traditionelle Wafersägen mit Innenlochsägen oder geführten Drähten (Diamantbesatz oder Schleifsuspension/Slurry) dar. Bei diesen Verfahren entsteht durch Verlaufen der Drähte beim Trennläppen eine Dickenvarianz. Als Folge dieser Dickenvarianz verwölben und verbiegen sich die Wafer. Die weiterverarbeitenden Halbleiterhersteller akzeptieren nur gewisse Grenzen dieser Ebenheitsabweichungen. Aus diesem Grund müssen die Halbleiterscheiben nach dem Vereinzeln noch durch eine Reihe von Oberflächenbehandlungen aufbereitet werden. Dazu wird die Ebenheit/Planarität, Planparallelität und Rauigkeit mit Ätz-, Läpp- und chemisch mechanischen Polierschritten eingestellt.

Auch beim Coldsplit können Abweichungen der Oberflächeneigenschaften entstehen. Diese Abweichungen können in der dem Split folgenden Planarisier- und Polierschritte sowohl vom Wafer als auch vom Ingot entfernt werden.

Für die Wafer bedeutet ein planer Split weniger Planarisierabtragsreserve, was die Gesamtmaterialeffizienz des Cold Split Verfahrens gegenüber herkömmlichen Wafering-Verfahren noch weiter erhöht. Als Gesamtmaterialeffizienz wird das Verhältnis der genutzten Waferdicke, also Anzahl fehlerfreier Wafer mit Endmaß (z.B. 23 Wafer á $350\mu$m Dicke = Nutzdicke $8050\mu$m) zur Ausgangsdicke des Halbleiterbarrens (Ingot oder Boule, z.B. $25000\mu$m) bezeichnet. Im Beispiel können mit einem planaren lasermodifizierten Cold Split die Waferausbeute auf 84% gegenüber <40% beim herkömmlichen Wafering erhöht werden.

Für den verbleibenden Halbleiterbarren muss die Planarität vor dem nächsten Laserprozess wieder hergestellt werden, da sich sonst die Abweichungen über den weiteren Prozess fortpflanzen und sich eventuell sogar verstärken. Die Verstärkung entsteht aufgrund unterschiedlicher optischer Weglängen in optisch sehr hochbrechenden Materialen (z.B. Si: n=3,6; SiC: n=2,6). Schwankt also der Abstand des Laserkopfes zur Oberfläche, so durchläuft der Laserstrahl bis zum Fokus optische Pfade unterschiedliche Brechzahl auch mit unterschiedlicher Länge. Ein Fehler im Abstand zur Oberfläche um $1\mu$m ruft demnach einen n-fachen Fehler innerhalb des Materials hervor.

Um eine sehr hohe Planarität der Laserebene zu erreichen, sind Abweichungen über die Waferlänge im $\mu$m-Bereich zulässig, die jedoch mit mechanischem Keilausgleich schlecht und mit reinem Autofokus nur bedingt erzielbar sind.

Beispielsweise bei Maskenbelichtungsautomaten, die mit einer Abstandsbelichtung (proximity Photolithographie) arbeiten, ist ein mechanischer Keilausgleich im $\mu$m-Bereich Stand der Technik. Allerdings werden hier nur extrem planare Masken und Substrate statisch ausgeglichen, denn die Probe bewegt sich nicht hochdynamisch gegenüber der Bearbeitungsoptik. Mittels des mechanischen Keilausgleichs sind lediglich statische Anwendungen durchführbar und nur Ausgleichsebenen (zweiachsige Verkippung) kompensierbar.

Der klassische Autofokus hält den Abstand einer Bearbeitungsoptik zu einer Oberfläche konstant. Auf diese Weise kann auch in der Laser-Mikrobearbeitung von Oberflächen im $\mu$m-Bereich nachgeführt werden. In der Oberflächenbearbeitung durchläuft der Laser naturgemäß nur ein Medium (zumeist Luft) bis zum Fokuspunkt. Der klassische Autofokus hat die Nachteile, dass nur eine Nachführung des Oberflächenprofils möglich ist, dass eine Verstärkung des Profils um den Faktor der Substratbrechzahl erfolgt und dass keine Planarisierung möglich ist.

Ferner sind neben dem mechanischen Keilausgleich und dem klassischen Autofokus ebenfalls die Verfahren 3D Photo-Lithographie mit Mehrphotonenabsorption und Planarisierung vor dem Lasern bekannt.

Das Verfahren 3D Photo-Lithographie mit Mehrphotonenabsorption ähnelt der Lasermodifikation im Volumen sehr stark, da hier der Fokuspunkt im Bearbeitungsvolumen manipuliert wird, während umgebendes Material unmodifiziert bleibt. Diese Prozesse arbeiten mit oder Flüssig-Photoresisten und sind daher sowohl an der Oberfläche plan und glatt (Oberflächenspannung, Wasserwaagenprinzip). Häufig wird das Objektiv hier direkt im Resist (Immersion) manipuliert und erfährt damit keine Ausbreitung in unterschiedlichen Medien. Diese Verfahren ist nachteilig, da ein System mit nur einem homogenen Medium/ ohne Interface vorliegt.

Ferner existieren Planarisierungs- und Polierverfahren, die die Ebenheit und Rauheit in fast beliebiger Güte herstellen können. Der apparative Aufwand und damit einher die Bearbeitungskosten schwanken jedoch erheblich. Dieses Verfahren ist nachteilig, da eine zusätzliche Materialreserve erforderlich ist, wodurch sich eine geringere Ausbeute oder Gesamtmaterialeffizienz ergibt und erhöhte Prozesskosten resultieren. Ferner liegt keine Ersparnis des Autofokus vor, da ohnehin noch Platzierungsfehler korrigiert werden.

Es ist somit Aufgabe der vorliegenden Erfindung ein Verfahren und eine Vorrichtung bereitzustellen, welche auch bei Festkörpern, insbesondere bei großen Festkörpern mit mehr als 6 Zoll Durchmesser, eine sehr präzise Erzeugung von Modifikationen im Inneren der Festkörper ermöglicht. Bevorzugt sollen die von einem Festkörper mittels einer Rissausbreitung abgetrennten Festkörperanteile bzw. Schichten einen geringeren Aufwand hinsichtlich der Nacharbeit verursachen, d. h. beabstandet zur Oberfläche des Festkörpers.

Die zuvor genannte Aufgabe wird erfindungsgemäß durch ein Verfahren gemäß Anspruch 1 gelöst. Das erfindungsgemäße Verfahren dient zur Erzeugung von Modifikationen in einem Festkörper, wobei durch die Modifikationen ein Rissführungsbereich zum Führen eines Risses zum Abtrennen eines Festkörperanteils, insbesondere einer Festkörperschicht, von dem Festkörper vorgegeben wird. Bevorzugt umfasst das erfindungsgemäße Verfahren mindestens die Schritte: Bewegen des Festkörpers relativ zu einer Laserbeaufschlagungseinrichtung, nacheinander erzeugen bzw. aufeinanderfolgendes Emittieren von einer Vielzahl an Laserstrahlen mittels der Laserbeaufschlagungseinrichtung zum Erzeugen von jeweils mindestens einer Modifikation innerhalb des Festkörpers, wobei die Laserbeaufschlagungseinrichtung (8) zur definierten Fokussierung der Laserstrahlen und/oder zur Anpassung der Laserenergie kontinuierlich in Abhängigkeit von mindestens einem Parameter und bevorzugt einer Vielzahl an Parametern, insbesondere mindestens zwei Parametern, eingestellt wird.

Diese Lösung ist vorteilhaft, da eine Verfahren bereitgestellt wird, das den Fokus innerhalb des Materials nicht direkt der Oberfläche nachführt, sondern mit Korrekturen versieht. Sind diese Abweichungen in Echtzeit zu erfassen, so kann auch eine einfache Regelung mit Korrekturfaktoren vorgenommen werden. Die Korrekturfaktoren entsprechen hierbei bevorzugt den zur Einstellung der Laserbeaufschlagungseinrichtung herangezogenen Parametern.

Die Position des Fokus innerhalb eines Materials ist auch eine Funktion der Brechzahl und der Bearbeitungstiefe (Abbildungsfehler sind materialabhängig).

Das erfindungsgemäße Verfahren kann bevorzugt auch als neuartige Regelung zur Fokusnachführung als Echtzeitsystem verstanden werden.

Die Einstellung der Laserbeaufschlagungseinrichtung erfolgt bevorzugt mittels eines durch eine Steuerungseinrichtung ausgeführten Algorithmus, insbesondere zur Unterscheidung von Substratverkippung durch Platzierungsfehler (Verkippung gegenüber Maschinenhalter) und/oder Ebenheitsfehler des Halbleiterbarrens.

Als Modifikation wird im Rahmen der vorliegenden Erfindung eine Veränderung der Gitterstruktur des Festkörpers verstanden, insbesondere erfolgt die Veränderung der Gitterstruktur infolge einer Mehrphotonenanregung.

Weitere bevorzugte Ausführungsformen der vorliegenden Erfindung sind Gegenstand der Unteransprüche und/oder der nachfolgenden Beschreibungsteile.

Gemäß einer bevorzugten Ausführungsform der vorliegenden Erfindung ist ein erster Parameter die mittlere Brechzahl des Materials des Festkörpers oder die Brechzahl des Materials des Festkörpers ist in dem Bereich des Festkörpers, der zur Erzeugung einer definierten Modifikation von Laserstrahlen zu durchqueren ist, und ein zweiter Parameter ist die Bearbeitungstiefe in dem Bereich des Festkörpers, der zur Erzeugung einer definierten Modifikation von Laserstrahlen zu durchqueren ist. Diese Ausführungsform ist vorteilhaft, da die Parameter Bearbeitungstiefe und Brechzahl erhebliche Auswirkungen auf die Präzision des erzeugten Fokuspunkts haben.

Gemäß der Erfindung ist ein Parameter der Grad der Dotierung des Festkörpermaterials, der bevorzugt durch die Analyse von zurückgestreutem Licht (bevorzugt Raman-Streuung) bestimmt wird, wobei das zurückgestreute Licht eine andere Wellenlänge oder einen anderen Wellenlängenbereich aufweist als zum Auslösen der Zurückstreuung definiert eingestrahltes Licht, wobei ein Raman-Instrument Bestandteil der Vorrichtung ist und der Grad der Dotierung mittels des Raman-Instruments bestimmt wird, wobei ein oder mehrere oder alle dieser Parameter bevorzugt mittels eines gemeinsamen Detektionskopfes, insbesondere zeitgleich, erfasst werden. Die Ramanspektroskopie wird bevorzugt ebenefalls bei Gläsern, Saphir, Aluminiumoxidkeramik eingesetzt. Das Raman-Verfahren ist vorteilhaft, da es in der Tiefe des Materials misst, aber nur von einer Seite, keine hohe Transmission benötigt und durch einen Fit an das Raman-Spektrum die Ladungsträgerdichte/Dotierung ausgibt, die mit den Laserparametern korreliert werden kann.

Der erste Parameter wird gemäß einer weiteren bevorzugten Ausführungsform der vorliegenden Erfindung mittels eines Brechzahlbestimmungsmittels, insbesondere mittels spektraler Reflektion, bestimmt und/oder der zweite Parameter wird mittels eines Topografiebestimmungsmittels, insbesondere mittels eines konfokal-chromatischen Distanzsensors, bestimmt.

Daten zu den Parametern, insbesondere zu dem ersten Parameter und zu dem zweiten Parameter, werden gemäß einer weiteren bevorzugten Ausführungsform der vorliegenden Erfindung in einer Datenspeichereinrichtung bereitgestellt und werden zumindest vor der Erzeugung der Modifikationen einer Steuerungseinrichtung zugeführt, wobei die Steuerungseinrichtung die Laserbeaufschlagungseinrichtung in Abhängigkeit vom jeweiligen Ort der zu erzeugenden Modifikation einstellt. Insbesondere die Brechzahlschwankungen über den Halbleiterbarren sind nicht immer hochaufgelöst oder für Echtzeitsteuerungen schnell genug erfassbar. Daher ist hier eine Fokusführung mit Vorwissen nötig. Das Vorwissen wird hierbei durch die Daten zu den Parametern repräsentiert die vor der Bearbeitung bzw. der Modifikationserzeugung erfasst bzw. bestimmt bzw. erzeugt werden.

Die Steuerungseinrichtung zur Einstellung der Laserbeaufschlagungseinrichtung verarbeitet gemäß einer weiteren bevorzugten Ausführungsform der vorliegenden Erfindung ebenfalls Distanzdaten zu einem Distanzparameter, wobei der Distanzparameter den Abstand des jeweiligen Ortes, an dem Laserstrahlen zur Erzeugung der jeweiligen Modifikation in den Festkörper zum Zeitpunkt der Modifikationserzeugung eingeleitet werden, gegenüber der Laserbeaufschlagungseinrichtung wiedergibt, wobei die Distanzdaten mittels einer Sensoreinrichtung erfasst werden. Diese Ausführungsform ist vorteilhaft, da die schnelle Echtzeitregelung mit Distanzsensor und einstellbaren Korrekturfaktoren um eine ortsabhängige Steuerung der Korrekturfaktoren ergänzt werden kann.

Gemäß einer weiteren bevorzugten Ausführungsform der vorliegenden Erfindung erfolgt die Einstellung der Laserbeaufschlagungseinrichtung in Abhängigkeit von einer während der Modifikationserzeugung erfolgenden Bestimmung des ersten Parameters und des zweiten Parameters mittels jeweils eines Sensormittels, insbesondere einem Brechzahlbestimmungsmittel und einem Topografiebestimmungsmittel.

Gemäß einer weiteren bevorzugten Ausführungsform der vorliegenden Erfindung ist der Festkörper an einer Aufnahmeeinrichtung angeordnet, wobei die Aufnahmeeinrichtung in X-/Y-Richtung verfahrbar ist oder um eine Rotationsaachse rotierbar ist, wobei die Rotationsgeschwindigkeit der Aufnahmeeinrichtung mittels einer Antriebseinrichtung in Abhängigkeit vom Abstand des Ortes an dem die Laserstrahlen in den Festkörper eindringen zu der Rotationsachse variierbar ist, wobei die Rotationsgeschwindigkeit mit einer Abnahme des Abstands des Ortes, an dem die Laserstrahlen in den Festkörper eindringen, zur Rotationsachse bevorzugt ansteigt oder wobei die Aufnahmeeinrichtung mit mehr als 100 Umdrehungen pro Minute bevorzugt mit mehr als 1000 Umdrehungen pro Minute und besonders bevorzugt mit mehr als 1500 Umdrehungen pro Minute um die Rotationsachse rotierbar ist und Laserstrahlen mit einer Frequenz von mindesten 0,5 MHz bevorzugt von mindestens 1 MHz und besonders bevorzugt von mindestens 5 MHz oder 10 MHz zum Erzeugen der Modifikationen von der Laserbeaufschlagungseinrichtung emittierbar sind.

Gemäß einer weiteren bevorzugten Ausführungsform der vorliegenden Erfindung dringen die Laserstrahlen über eine Oberfläche des abzutrennenden Festkörperanteils in den Festkörper ein, wobei der abzutrennende Festkörperanteil eine geringere mittlere Dicke aufweist als der verbleibende Festkörper.

Ein zusätzlicher oder alternativer Parameter ist gemäß einer weiteren bevorzugten Ausführungsform der vorliegenden Erfindung der Grad der Dotierung des Festkörpers an einem vorbestimmten Ort oder in einem vorbestimmten Bereich, insbesondere im Inneren, des Festkörpers, insbesondere beabstandet zur Festkörperoberfläche. Bevorzugt wird der Grad der Dotierung derart mit Ortsinformationen verknüpft, dass eine Behandlungskarte entstehet bzw. ortsaufgelöste Behandlungsanweisung bereitgestellt werden, die ortsabhängig die Laserparameter, insbesondere Laserfokus und/oder Laserenergie, und/oder weitere Maschinenparameter, insbesondere die Vorschubgeschwindigkeit, vorgibt bzw. vorgeben.

Der Grad der Dotierung wird gemäß einer weiteren bevorzugten Ausführungsform der vorliegenden Erfindung durch die Analyse von zurückgestreutem Licht mit einer unelastischen Streuung (Raman-Streuung) bestimmt, wobei das zurückgestreute Licht eine andere Wellenlänge oder einen anderen Wellenlängenbereich aufweist als zum Auslösen der Rückstreuung definiert eingestrahltes Licht, wobei das rückgestreute Licht von dem vordefinierten Ort aus oder von dem vorbestimmten Bereich aus rückgestreut wird.

Diese Ausführungsform ist vorteilhaft, da im Laserverfahren, insbesondere auf SiC (aber auch anderen Materialien) der Prozess ortsangepassst geführt werden muss (z.B. andere Laserenergie, etc.). Es wurde erfindungsgemäß erkannt, dass z.B. bei SiC hierfür insbesondere die Dotierung entscheidend ist, da diese die Transparenz des Materials für die Bearbeitungswellenlänge ändert und höhere Laserenergien erforderlich macht.

Der Grad der Dotierung wird gemäß einer weiteren bevorzugten Ausführungsform der vorliegenden Erfindung mittels einer ellipsometrischen Messung (z.B. Müller-Matrix-Ellipsometrie mit Rückseitenreflexion) bestimmt. Die ellipsometrischen Messung beruht bevorzugt auf einer optischen Transmission des Materials.

Gemäß einer weiteren bevorzugten Ausführungsform der vorliegenden Erfindung wird der Grad der Dotierung mittels einer rein optisch kalibrierten Transmissionsmessung bestimmt, wobei die Kalibrierung mittels Hall-Messung und 4-Punkt-Messung bewirkt wird. Dieses Verfahren kann ebenfalls die Dotierung/Zahl der freien Ladungsträger im Material ermitteln, die dann die für den Prozess benötigte Laserenergie ermitteln lässt.

Der Grad der Dotierung wird gemäß einer weiteren bevorzugten Ausführungsform der vorliegenden Erfindung mittels einer Wirbelstrommessung bestimmt, wobei bevorzugt Leitfähigkeitsunterschiede im Festkörpermaterial bestimmt und ausgewertet werden.

Bei Wirbelstrommessungen bzw. bei Verwendung von Wirbelstromsensoren bzw. in der Wirbelstrommesstechnik wird bevorzugt eine Sende- und Empfangsspule genutzt, um lokale Leitfähigkeitsunterschiede zu detektieren. In der Sendespule wird eine hochfrequentes elekromagnetisches primäres Wechselfeld erzeugt. Im leitfähigen Material werden dann Wirbelströme (lokal fliessende Ströme) induziert, die wiederum ein sekundäres entgegen gerichtetes elektromagnetisches Wechselfeld hervorrufen. Die Überlagerung dieser Felder kann gemessen, separiert und ausgewertet werden. Damit können verschiedene Qualitätsmerkmale (Schichtdicke, dem Schichtwiderstand, der Materialhomogenität) hauptsächlich dünner Leitschichten aber auch von Bulkmaterial gemessen werden. In Transmissionsanordnung (Prüfkörper zwischen Sende- und Empfangsspule) werden optimale Auflösungen erreicht, aber auch die Anordnung beider Spulen auf einer Probenseite für Reflexionsmessungen ist möglich. Durch angepasstes Design der Spulen und Frequenzwahl können unterschiedliche Eindringtiefen und Sensitivitäten genutzt werden.

Grundsätzlich gibt es somit eine Vielzahl von Messmethoden, mit denen im Prinzip die Dotierung gemessen werden kann. Wichtig ist hier ein schnelles, kontaktloses, zerstörungsfreies Verfahren.

Ferner bezieht sich die vorliegende Erfindung auf ein Verfahren zum Abtrennen von mindestens einer Festkörperschicht von einem Festkörper, siehe Anspruch 9. Das erfindungsgemäße Verfahren umfasst dabei mindestens einen der Ansprüche 1 bis 8. Ferner umfasst das erfindungsgemäße Verfahren die Erzeugung von so vielen Modifikationen in dem Festkörper, dass sich die Festkörperschicht infolge der Modifikationserzeugung ablöst oder das erfindungsgemäße Verfahren umfasst den die Schritte: Anordnen oder Erzeugen einer Aufnahmeschicht an dem Festkörper, wobei die Aufnahmeschicht ein Polymermaterial, insbesondere Polydimethylsiloxan oder ein Elastomer oder ein Epoxidharz oder eine Kombination daraus, aufweist oder daraus besteht, und das Polymermaterial infolge einer thermischen Beaufschlagung der Aufnahmeschicht zum, insbesondere mechanischen, Erzeugen von Rissausbreitungsspannungen in dem Festkörper einen Glasübergang erfährt, wobei sich durch die Rissausbreitungsspannungen ein Riss in dem Festkörper entlang dem Rissführungsbereich ausbreitet.

Gemäß einer weiteren bevorzugten Ausführungsform der vorliegenden Erfindung weist die Aufnahmeschicht massemäßig zumindest mehrheitlich und bevorzugt vollständig ein Polymermaterial auf oder besteht daraus, wobei der Glasübergang des Polymermaterials zwischen -100°C und 0°C, insbesondere zwischen -85°C und -10°C oder zwischen -80°C und -20°C oder zwischen -65°C und -40°C oder zwischen -60°C und -50°C, liegt.

Die Aufnahmeschicht besteht bevorzugt aus einem Polymer-Hybrid-Material besteht oder weist ein solches auf, das besonders bevorzugt eine Polymermatrix ausbildet, wobei sich in der Polymermatrix ein Füllstoff befindet, wobei die Polymermatrix bevorzugt eine Polydimethylsiloxan-Matrix ist und wobei der Masseanteil der Polymermatrix am Polymer-Hybrid-Material bevorzugt 80 % bis 99 % und besonders bevorzugt 90 % bis 99 % beträgt. Die Aufnahmeschicht wird bevorzugt als vorgefertige Folie bereigestellt und an den Festkörper angekoppelt, insbesondere angeklebt oder angebondet.

Erfindungsgemäß wird daher ein Polymer-Hybrid-Material zur Verwendung in einem Splitting-Verfahren angegeben, bei welchem aus einem Festkörper-Ausgangsmaterial zumindest zwei Festkörper-Teilstücke erzeugt werden. Das erfindungsgemäße Polymer-Hybrid-Material umfasst eine Polymermatrix und zumindest einen darin eingebetteten ersten Füllstoff. Insofern im Folgenden von einem bzw. dem Füllstoff die Rede ist, soll gleichfalls die Möglichkeit mehrerer Füllstoffe mit einbezogen sein. Beispielsweise kann der Füllstoff eine Mischung verschiedener Materialien umfassen, z. B. Metallpartikel und anorganische Fasern.

Als Polymermatrix kann jedes Polymer oder eine Mischung verschiedener Polymere genutzt werden, mit dessen Hilfe sich die für eine Teilung des Festkörper-Ausgangsmaterials notwendigen Spannungen erzeugen lassen. Beispielsweise kann die Polymermatrix als Elastomermatrix, bevorzugt als Polydiorganolsiloxan-Matrix, besonders bevorzugt als Polydimethylsiloxan-Matrix, ausgebildet sein. Derartige Polymermaterialien lassen sich besonders einfach als Matrixmaterial in Kombination mit Füllstoffen nutzen, da die Eigenschaften aufgrund des variierbaren Vernetzungsgrads flexibel eingestellt und an den jeweiligen Füllstoff sowie das zu teilende Festkörper-Ausgangsmaterial angepasst werden können. Gemäß einer Ausführungsvariante beträgt der Masseanteil der Polymermatrix am Polymer-Hybrid-Material 80 % bis 99 %, 10 bevorzugt 90 % bis 99 %.

Der erste Füllstoff kann organischer oder anorganischer Natur sein und sowohl aus einem chemischen Element als auch aus einer chemischen Verbindung oder einem Stoffgemisch, beispielsweise einer Legierung, bestehen.

Der erste Füllstoff ist derart aufgebaut, dass er als Reaktant, Initiator, Katalysator oder Promotor während des Ablösens des Polymer-Hybrid-Materials vom Festkörper- Teilstück nach der Teilung wirkt und dadurch im Vergleich zu einem Polymermaterial ohne ersten Füllstoff zu einem schnelleren Ablösen des Polymer-Hybrid-Materials vom Festkörper-Teilstück nach der Teilung führt.

Die konkrete chemische Zusammensetzung und Ausgestaltung des ersten Füllstoffs sowie dessen Masseanteil ist dabei insbesondere abhängig vom konkreten Material der Polymermatrix, welche abgelöst werden soll, dem dafür genutzten Lösungsmittel und den verwendeten Reaktanten. Weiterhin spielen auch das Material des Festkörper-Ausgangsmaterials und die Dimensionen des zu teilenden Festkörper-Ausgangsmaterials eine Rolle.

Der konkrete Anteil des ersten Füllstoffs in der Polymermatrix ist stark vom Material des Füllstoffs und dessen Wirkungsweise abhängig. Zum einen muss die Polymermatrix trotz Füllstoff ihrer Aufgabe der Erzeugung von Spannungen noch gerecht werden können. Zum anderen muss der Anteil des ersten Füllstoffs hoch genug sein, um die angestrebte Beeinflussung der Polymerentfernung zu erreichen. Den jeweils optimalen Masseanteil des ersten Füllstoffs kann der Fachmann im Rahmen einfacher konzentrationsabhängig durchgeführter Versuche ermitteln.

Zur Verbesserung der mechanischen Eigenschaften kann zusätzlich ein weiterer Füllstoff, wie z. B. pyrogene Kieselsäure in Form eines anorganischen Netzwerkes im Polymer beitragen. Neben diesen starken Wechselwirkungen in Form des Netzwerks können auch weniger starke Interaktionen durch rein hydrodynamische Verstärkungen zur Verbesserung beitragen. Beispielhaft ist hier eine gezielte Steigerung der Viskosität zu nennen, die eine verbesserte Verarbeitung im Splitting-Verfahren ermöglicht und so zu verbesserten Fertigungstoleranzen beitragen kann. Weiterhin wird durch diese Wechselwirkung eine Verringerung der inneren Freiheitsgrade hinsichtlich einer strukturellen Umorientierung mit zunehmender Bewehrung erschwert.

Dies führt zu einer gewünschten Erniedrigung der Glasübergangstemperatur des eingesetzten Polymers im Polymer-Hybrid-Material, was den Vorteil einer geringeren Temperatur im Splitting-Verfahren ermöglicht. Erfindungsgemäß wird der erste Füllstoff in einem Polymer-Hybrid-Material zur Beschleunigung des Ablösens des Polymer-Hybrid-Materials von einem Festkörper-Teilstück, das durch Teilung mittels eines Splittingverfahrens, bei dem ein Festkörper-Ausgangsmaterial in zumindest zwei Festkörper-Teilstücke geteilt wird, erhalten wird, verwendet.

Der erste Füllstoff kann in der Polymermatrix derart verteilt sein, dass der Masseanteil des ersten Füllstoffs ausgehend von der äußeren, d. h. unteren, Grenzfläche des Polymer-Hybrid-Materials, die während des Splitting-Verfahrens mit dem Festkörper-Ausgangsmaterial verbunden ist, in Richtung einer parallel zur unteren Grenzfläche angeordneten weiteren Grenzfläche des Polymer-Hybrid- Materials, abnimmt. Dies bedeutet, dass der Masseanteil des Füllstoffs nahe beim Festkörper-Ausgangsmaterial bzw. Teilstück größer ist als in den übrigen Bereichen des Polymer-Hybrid-Materials. Diese Verteilung des ersten Füllstoffs ermöglicht eine besonders effektive Entfernung des Polymer-Hybrid-Materials nach der Trennung, da sich der der erste Füllstoff nahe an der Grenzfläche zum Festkörper-Teilstück befindet und dort seine Wirkung entfalten kann. Geleichzeitig weisen die restlichen Bereiche des Polymer-Hybrid-Materials weniger oder gar keine Anteile des ersten Füllstoffs auf, so dass die Funktion des Polymers möglichst wenig beeinflusst wird.

In einer Ausgestaltung ist das Polymer-Hybrid-Material schichtförmig aufgebaut, wobei lediglich eine dem Festkörper-Ausgangsmaterial zugewandte Schicht den ersten Füllstoff aufweist, während das restliche Polymer-Hybrid-Material frei vom ersten Füllstoff ist.

Weiterhin kann ein unterer Bereich des Polymer-Hybrid-Materials, der direkt an dessen untere Grenzfläche angrenzt frei von dem ersten Füllstoff sein. Damit kann sich eine Bereichsabfolge wie folgt ergeben: Benachbart zum Festkörper-Ausgangsmaterial befindet sich zunächst ein Bereich ohne ersten Füllstoff, darauf folgt ein Bereich mit einem hohen Anteil an erstem Füllstoff und danach ein Bereich mit niedrigem Anteil an erstem Füllstoff oder ohne ersten Füllstoff.

Diese und alle im Folgenden beschriebenen Bereiche können in Form von Schichten ausgebildet sein, d. h. der Bereich erstreckt sich überwiegend parallel zu der Grenzfläche des Festkörper-Ausgangsmaterials, auf die das Polymer-Hybrid-Material aufgebracht wird und weist eine Längs- und Querausdehnung zumindest im Bereich dieser Grenzfläche auf.

Ein unterer Bereich ohne ersten Füllstoff kann insbesondere für den Fall vorgesehen werden, dass der erste Füllstoff die Haftung des Polymer-Hybrid-Materials auf dem Festkörper-Ausgangsmaterial verschlechtert. Um dies zu vermeiden, wird zunächst ein Bereich ohne ersten Füllstoff angeordnet, auf den ein Bereich mit einem hohen Anteil an erstem Füllstoff folgt, damit der erste Füllstoff seine Funktion erfüllen kann. Eine untere Schicht ohne ersten Füllstoff kann beispielsweise eine Dicke zwischen 10 $\mu$m und 500 $\mu$m, beispielsweise 100 $\mu$m, aufweisen.

Weiterhin kann ein oberer Bereich des Polymer-Hybrid-Materials, der direkt an dessen obere Grenzfläche angrenzt frei von dem ersten Füllstoff sein. Unter der oberen Grenzfläche ist dabei die Grenzfläche zu verstehen, die das Polymer-Hybrid-Material gegenüberliegend zur unteren Grenzfläche und zum Festkörper-Ausgangsmaterial zur Umgebung hin begrenzt. Untere und obere Grenzfläche können parallel zueinander angeordnet sein.

Ein solcher oberer Bereich ohne ersten Füllstoff kann insbesondere dann vorgesehen werden, wenn der erste Füllstoff die Wärmeübertragung zwischen Umgebung und Polymer-Hybrid-Material nachteilig beeinflusst, beispielsweise wenn die Abkühlung des Polymer-Hybrid-Materials verzögert werden würde.

Der erste Füllstoff kann ein Material umfassen oder aus einem Material bestehen, dass mit einem Reaktionsmittel, bevorzugt einem Oxidationsmittel unter Freisetzung eines gasförmigen Produkts reagieren kann.

Dadurch sind in der Polymermatrix Kavitäten generierbar, die einen schnelleren Zugang der Reaktanten und Lösungsmittel zur Polymermatrix und einer etwaige vorhandenen Opferschicht ermöglichen und zudem einen schnelleren Abtransport der Edukte und gelösten Bestandteile bewirken.

Durch die Generierung gasförmiger Reaktionsprodukte können zusätzliche Triebkräfte eingebracht werden, die die Entfernung des Polymer-Hybrid-Materials weiter unterstützen.

Die Ausbildung zusätzlicher Kavitäten sowie das Entstehen gasförmiger Reaktionsprodukte beschleunigt die Polymerentfernung und trägt daher zu einer Erhöhung der Gesamtausbeute des Splitting-Verfahrens bei. Durch Variation des Anteils an erstem Füllstoff kann die Kavitätendichte im Grenzbereich zwischen Festkörper-Teilstück und Polymer-Hybrid-Material bzw. zwischen Opferschicht und Polymer- Hybrid-Material gezielt beeinflusst werden.

Der erste Füllstoff kann ein Metall, insbesondere Aluminium, Eisen, Zink und/oder Kupfer umfassen oder aus einem Metall, insbesondere den zuvor genannten Metallen, bestehen.

"Bestehend aus" schließt auf alle vorliegend genannten Materialien bezogen ein, dass technologisch bedingte Verunreinigungen oder technologisch bedingte Beimengungen, die z. B. der Herstellung der Füllstoffe sowie deren Verteilung oder Anbindung an die Polymermatrix dienlich sind, enthalten sein können.

Metallische Füllstoffe können mit Oxidationsmitteln wie z.B. Salzsäure, Salpetersäure, Zitronensäure, Ameisensäure oder Sulfaminsäure reagieren unter Freisetzung eines gasförmigen Produkts reagieren und dadurch aus dem Polymer-Hybrid-Material entfernt werden.

Beispielsweise reagiert Aluminium mit konzentrierter Salzsäure unter Ausbildung von solvatisierten Metallionen und Wasserstoff gemäß folgender Gleichung:6 HCl + 2 Al + 12 H2O ! 2 [AlCl3*6 H2O] + 3 H2

In ähnlicher Weise führt die Reaktion von Zink als Füllstoff durch Reaktion mit konzentrierter Salzsäure zur Bildung 5 zusätzlicher Kavitäten: Zn + 2 HCl!ZnCl2 + H2 In den genannten Beispielen werden durch die Generierung von Wasserstoff, zusätzliche Triebkräfte eingebracht, die die Entfernung des Polymer-Hybrid-Materials weiter unterstützen. Zudem kann der erste Füllstoff die Temperaturleitfähigkeit innerhalb des Polymer-Hybrid-Materials verbessern, beispielsweise, indem der erste Füllstoff eine höhere Temperaturleitfähigkeit als das Polymer der Polymermatrix aufweist. Dies kann beispielsweise der Fall sein, wenn Ein weiterer Vorteil für den Fall, dass der erste Füllstoff ein Metall umfasst, liegt in der verbesserten Temperaturleitfähigkeit innerhalb des Polymer-Hybrid- Materials. Dadurch Durch eine verbesserte Temperaturleitfähigkeit sind können die für die Teilung des Festkörper-Ausgangsmaterials mittels Abkühlung erzeugten Spannungen effektiver, d. h. schneller und unter geringerem Verbrauch an Kühlmittel, generierbar sein. Dies erhöht kann die Gesamtausbeute des Splitting-Verfahrens erhöhen.

Weiterhin kann im Polymer-Hybrid-Material ein zweiter 25 Füllstoff vorgesehen sein, der die Haftung des Polymer- Hybrid-Materials auf dem Festkörper-Ausgangsmaterial im Vergleich zu einem Polymer-Hybrid-Material ohne zweiten Füllstoff erhöht. Bevorzugt wird die Haftung im Vergleich zu einem Polymermaterial ohne Füllstoff erhöht.

Beispielsweise kann es sich bei dem zweiten Füllstoff um einen Füllstoff handeln, der mittels Plasma aktiviert werden kann. Durch die Plasmaaktivierung resultieren neue Oberflächenspezies, die so geschaffen werden können, dass eine stärkere Wechselwirkung mit der Oberfläche des Festkörper-Ausgangsmaterials resultiert und im Ergebnis die Haftung des Polymer-Hybrid-Materials verbessert wird.

Die Art der durch die Plasmabehandlung erzielbaren Oberflächenspezies ist dabei vorrangig von der Prozessführung des Plasmaprozesses abhängig. Beispielsweise können während der Plasmabehandlung Gase wie Stickstoff, Sauerstoff, Silane oder Chlorsilane zugefügt werden, so dass beispielsweise polare Gruppen entstehen, welche stärker mit der Oberfläche des Festkörper- Ausgangsmaterials wechselwirken können.

Der zweite Füllstoff kann in der Polymermatrix so verteilt 15 sein, dass der Masseanteil des zweiten Füllstoffs in Richtung der unteren Grenzfläche zunimmt. Beispielsweise kann das Polymer-Hybrid-Material den zweiten Füllstoff lediglich in einem Bereich angrenzend an die untere Grenzfläche enthalten, wobei der Bereich auch als Schicht im Sinne der oben genannten Definition ausgebildet sein kann.

Dies ermöglicht die Anordnung des zweiten Füllstoffs bevorzugt in der Nähe der Grenzfläche zwischen Polymer-Hybrid-Material und Festkörper-Ausgangsmaterial, wodurch die Haftung verbessert und damit eine größere Kraftübertragung in das zu teilende Festkörper-Ausgangsmaterial ermöglicht wird. Beispielsweise kann der zweite Füllstoff Kern-Schale-Polymerpartikel bzw. Core-Shell-Polymerpartikel umfassen.

Dabei sind Partikel bevorzugt, deren Polymerzusammensetzung sich von der Polymermatrix des Polymer-Hybrid-Materials dahingehend unterscheidet, dass insbesondere die Oberfläche, d. h. die Schale, der Kern-Schale-Partikel stärker aktivierbar ist, z. B. mittels Niedertemperaturplasmas.

Beispiele hierfür sind Kern-Schale-Partikel umfassend einen Polysiloxan-Kern mit einer Acrylat-Schale oder umfassend einen nanoskaligen Silikat-Kern mit einer Epoxid-Schale oder umfassend einen Kautschukpartikel-Kern mit eines Epoxid-Schale oder umfassend einen Nitrilkautschukpartikel-Kern mit einer Epoxid-Schale. Der zweite Füllstoff kann mittels Niedertemperaturplasma, z.B. Kaltplasma, aktivierbar sein. Beispielsweise kann das Plasma mittels dielektrischer Barriereentladung (DBE) erzeugt werden. Hierbei können Elektronendichten im Bereich von 1014 bis 1016 m-3 erzeugt werden. Die durchschnittliche Temperatur des durch DBE erzeugten "kalten" Nichtgleichgewichtsplasmas (Plasmavolumen) beträgt ca. 300 $\pm$ 40 K bei Umgebungsdruck. Die durchschnittliche Temperatur des durch DBE erzeugten nichtthermischen Plasmas beträgt ca. 70 °C bei Umgebungsdruck.

Bei der DBE-Behandlung wird die Oberfläche beispielsweise mit uni- oder bipolaren Pulsen von Pulsdauern von wenigen Mikrosekunden bis zu einigen zehn Nanosekunden und Amplituden im einstelligen bis zweistelligen Kilovoltbereich beaufschlagt. Hierbei sind keine metallischen Elektroden im Entladungsraum und somit keine metallischen Verunreinigungen oder Elektrodenverschleiß zu erwarten.

Vorteilhaft ist zudem eine hohe Effizienz, da an den Elektroden keine Ladungsträger aus- oder eintreten müssen.

Dielektrische Oberflächen können bei niedrigen Temperaturen modifiziert und chemisch aktiviert werden. Die Oberflächenmodifikation kann beispielsweise durch eine Wechselwirkung und Reaktion der Oberflächenspezies durch Ionenbombardement erfolgen.

Weiterhin können gezielt Prozessgase, wie z. B. Stickstoff, Sauerstoff, Wasserstoff, Silane oder Chlorsilane, z. B. SixHyEz mitE=F,Cl,Br,I,O,Hundx=0bis10,z=0 bis 10, SiH4, Si(EtO)4 oder Me3SiOSiMe3, bei einer Plasmabehandlung zugefügt werden, um beispielsweise bestimmte chemische Gruppen an der Oberfläche zu erzeugen. Der zweite Füllstoff kann des Weiteren mittels Korona-5 Behandlung, Flammenbehandlung, Fluorierung, Ozonierung oder UV-Behandlung bzw. Eximer-Bestrahlung aktivierbar sein. Durch eine derartige Aktivierung werden beispielsweise polare Gruppen an der Oberfläche des zweiten Füllstoffs generiert, die mit der Oberfläche des Festkörper-Ausgangsmaterials wechselwirken können und so die Haftung verbessern. Das Polymer-Hybrid-Material kann weiterhin zusätzlich im Vergleich zu einem Polymer-Hybrid-Material mit einem ersten oder zu einem Polymer-Hybrid-Material mit einem ersten und einem zweiten Füllstoff einen dritten Füllstoff umfassen. Dieser dritte Füllstoff weist im Vergleich zu dem Polymer der Polymermatrix eine höhere Temperaturleitfähigkeit und/oder einen höheren Elastizitätsmodul auf.

Beispielsweise liegt der E-Modul des Polymers bei Tieftemperaturbedingungen im unteren einstelligen Gigapascalbereich (ca. 1-3 GPa), während beispielsweise metallische Füllstoffe einen E-Modul im zweistelligen bis dreistelligen Gigapascalbereich aufweisen. Bei einem entsprechenden hohen Füllstoffanteil ist ein perkolierendes Füllstoffnetzwerk möglich, was eine verbesserte "Krafteinkopplung" in das Festkörper-Ausgangsmaterial ermöglicht.

Die Perkolation wird wesentlich durch den Volumenfüllgrad der jeweiligen Füllstoffe beeinflusst (z. B. 0,1 Vol%, 130 Vol% bis 10 Vol% je nach Aspektverhältnis). Mit zunehmender Krafteinleitung kann der viskoelastische Schichtaufbau der Polymerstruktur eingetaucht werden und mehrere Perkolationspfade wirksam werden. Hier können verbesserte Wärmeübergänge ermöglicht werden, da es zu einem verbesserten Kontakt der Füllstoffe mit der Oberfläche des Festkörper-Ausgangsmaterials kommen kann.

Die mechanische Stabilität des Polymer-Hybrid-Materials wird auch bei tiefen Temperaturen schneller erreicht. In Summe kommt es zu einer geringeren Standardabweichung der entsprechenden Struktur-Eigenschaftsprofile wie z. B. Bruchspannung und Bruchdehnung des Polymer-Hybrid-Materials und somit zu einer Erhöhung der Gesamtausbeute des Splitting-Verfahrens. Die ortsaufgelösten Eigenschaftsprofiländerungen (Spannungsspitzen im Polymer-Hybrid-Material) und somit im Festkörper sind kleiner, was zu einer höheren Gesamtausbeute des Splitting-Verfahrens und einer besseren Qualität der erzeugten Festkörper-Teilstücke führt.

Der dritte Füllstoff kann einen verbesserten Wärmeübergang zwischen Umgebung und Polymer-Hybrid-Material und eine schnellere Wärmeleitung innerhalb des Polymer-Hybrid-Materials bewirken, sodass das Polymer-Hybrid-Material schneller abgekühlt werden kann und das Splitting-Verfahren insgesamt schneller und damit effektiver durchgeführt werden kann.

Durch eine Erhöhung des Elastizitätsmoduls lassen sich höhere Spannungen für die Teilung des Festkörper-Ausgangsmaterials erzeugen, so dass auch Festkörper-Ausgangsmaterialien geteilt werden können, für die eine besonders hohe Spannung benötigt wird.

Zudem kann der dritte Füllstoff auch der Beeinflussung des thermischen Ausdehnungskoeffizienten dienen. Ziel ist dabei ein möglichst großer Unterschied zwischen den Wärmeausdehnungskoeffizienten des Polymer-Hybrid-Materials und des zu teilenden Festkörper-Ausgangsmaterials, um zusätzliche, für die Teilung notwendige Spannungen erzeugen zu können. Bevorzugt weist der dritte Füllstoff einen hohen thermischen Ausdehnungskoeffizienten, d. h. einen Ausdehnungskoeffizienten, der höher als derjenige der Polymermatrix ist, auf. Beispielsweise kann der thermische Ausdehnungskoeffizient des dritten Füllstoffs mehr als 300 ppm/K betragen.

Der dritte Füllstoff kann so in der Polymermatrix verteilt sein, dass der Masseanteil des dritten Füllstoffs in Richtung der oberen Grenzfläche zunimmt, um einen schnelleren Wärmeübergang insbesondere an der Grenzfläche zur Umgebung zu ermöglichen.

Der dritte Füllstoff kann ein Metall, insbesondere Aluminium, Eisen, Zink und/oder Kupfer, umfassen oder aus einem der genannten Metalle bestehen. Metalle zeichnen sich im Allgemeinen durch eine hohe Wärmeleitfähigkeit und Temperaturleitfähigkeit aus.

Die beschriebenen Füllstoffe (erster, zweiter, dritter Füllstoff) können in partikulärer Form in der Polymermatrix verteilt vorliegen, wobei die Partikelgröße im μm- und nm-Bereich, bezogen auf zumindest eine Dimension des Partikels, liegen kann. Neben einer kugelförmigen Gestalt können die Füllstoffpartikel auch andere Ausgestaltungen, beispielsweise eine stäbchenförmige oder scheibenförmige Gestalt annehmen.

Die Füllstoffpartikel können sämtliche Partikelgrößenverteilungen aufweisen, beispielsweise monomodal oder bimodal, eng, insbesondere monodispers, oder breit. Die Füllstoffe können an die Polymermatrix sowohl physikalisch, z. B. durch Einbettung in das Polymernetzwerk, als auch chemisch angebunden sein. Weiterhin können einer oder mehrere der beschriebenen, Füllstoffe anorganische oder organische Fasern, beispielsweise Kohle-, Glas-, Basalt- oder Aramidfasern, umfassen oder aus solchen bestehen, sofern die zuvor beschriebenen Funktionen damit vereinbar sind. Optional kann auch ein weiterer Füllstoff hinzugefügt werden, der die genannten Fasern umfasst oder aus solchen besteht.

Fasern weisen üblicherweise stark anisotrope Eigenschaften auf. Durch eine richtungsabhängige Positionierung des Füllstoffs im Polymer-Hybrid-Material besteht die Möglichkeit einer gezielten Beeinflussung der für die Teilung des Festkörper-Ausgangsmaterials notwendigen Spannungen. Dies kann zur Erhöhung der Gesamtausbeute des Splitting-Verfahrens beitragen. Ein zusätzlicher Vorteil besteht in dem Falle, dass einorganischer oder anorganischer Füllstoff als Faserstoff mit einer stark anisotropen Struktur eingesetzt wird, darin, dass dadurch eine Verbesserung der mechanischen Eigenschaften innerhalb des Polymer-Hybrid-Materials erreicht werden kann.

Die beschriebenen Füllstoffe können zudem Kern-Schale- Partikeln umfassen oder daraus bestehen. Zusätzlich oder alternativ kann ein weiterer Füllstoff umfassend oder bestehend aus Kern-Schale-Partikeln im Polymer-Hybrid-Material vorgesehen sein.

Der Einsatz von Kern-Schale-Polymerpartikeln erlaubt zusätzlich neben einer verbesserten Aktivierbarkeit auch eine neue Gestaltung von energieabsorbierenden Mechanismen, die in Summe zu einer Schlagzähigkeits- und Bruchzähigkeitserhöhung, insbesondere einer Erhöhung der Tieftemperatur-Schlagzähigkeit, des Polymer-Hybrid-Materials beim Einsatz im Splitting-Verfahren führen können und somit ebenfalls zu einer höheren Gesamtausbeute des Splitting-Verfahrens beitragen können. Beispielsweise kann eine mechanische Zerstörung einer Folie aus einem Polymer-Hybrid-Material mit einer geringeren Wahrscheinlichkeit auftreten, so dass die Möglichkeit einer Wiederverwendung der Folie begünstigt werden kann.

Beispielhaft kann durch Unterbindung der Rissausbreitung aufgrund von Kern-Schale-Polymerpartikel eine Zerstörung der Folie beim Splitting-Verfahren verhindert werden und somit Wiederverwertungswege eröffnet werden.

Hierbei können enthaltene Elastomerpartikel eine plastische Deformation erfahren und Hohlräume bilden, wodurch weitere zusätzliche Energie aufgenommen werden kann. Ebenso ist eine zusätzliche Energieaufnahme durch das Scherfließen der Matrix kompensierbar, was insgesamt die mechanischen Eigenschaften verbessert. Kern-Schale-Partikel zeichnen sich dadurch aus, dass ein in der Regel kugelförmiger Kern aus einem Material von einer Schale aus einem zweiten Material umgeben ist. Die Schale kann entweder den Kern komplett umhüllen oder aber auch durchlässig sein. Bei den Materialien kann es sich sowohl um anorganische Materialien, wie z. B. Metalle, oder um organische Materialien, wie z. B. Polymere handeln. Beispielsweise können zwei verschiedene Metalle miteinander kombiniert werden. Es besteht aber auch die Möglichkeit, einen Kern aus einem Polymer mit einer Schale aus einem Metall oder einem zweiten Polymer zu umgeben.

Kern-Schale-Partikel ermöglichen die Kombination der Eigenschaften des ersten und zweiten Materials. Beispielsweise kann über einen preiswerten Polymerkern die Größe und Dichte der Füllstoffpartikel festgelegt werden, während die metallische Schale wie oben beschrieben reagieren kann. Aufgrund ihrer oftmals monodispersen Partikelgrößenverteilung lassen sich die Eigenschaften der Kern-Schale-Partikel zudem präzise vorhersagen und einstellen.

Darüber hinaus können ein oder mehrere Füllstoffe (erster, 5 zweiter und/oder dritter Füllstoff) Kohlenstoff in Form von Industrieruß (Carbon Black), Graphit, zerkleinerten Kohlenstofffasern (chopped carbon fiber), Kohlenstoffnanofasern (carbon nanofibers), bevorzugt in Form von Kohlenstoffnanoröhrchen (carbon nanotubes, CNT), wie z.B. mehrwandigen Kohlenstoffnanoröhrchen (multi-walled carbon nanotubes, MWCNT) sowie einwandigen Kohlenstoff-anoröhrchen (single-walled carbon nanotubes, SWCNT), umfassen oder aus diesen bestehen. Bei Kohlenstoffnanoröhrchen handelt es sich um zylinderförmige Graphitlagen, die aus einer unterschiedlichen Anzahl an Zylindern aufgebaut sind.

Bestehen diese Röhrchen nur aus einem Zylinder, so werden sie als singlewalled carbon nanotubes (SWCNT) bezeichnet. Sind zwei oder mehr Zylinder vorhanden, entstehen entweder double-walled (DWCNT) oder die multi-walled carbon nanotubes (MWCNT). Diese können vorzugsweise konzentrisch ineinander geschachtelt vorliegen.

Gemäß verschiedenen Ausführungsvarianten kann der dritte Füllstoff MWCNTs umfassen oder aus diesen bestehen, da diese eine besonders hohe Wärmeleitfähigkeit (> 3000 W*(m*K)-1) besitzen und gleichzeitig eine sehr hohe Reißfestigkeit im Bereich von 5-60 GPa aufweisen. Die hohe mechanische Stabilität zeigt sich dabei in hohen Reißwerten, extremer Elastizität und einer sehr guten Strapazierfähigkeit des Füllstoffs.

Grundlage hierfür sind die sp2 hybridisierten starken σ-C-C- Bindungen verbunden mit einem delokalisierten p-Orbital als n-Bindung zu drei benachbarten Kohlenstoffatomen. Hierbei sind Verbiegungen bis zu 90° möglich.

Mit SWCNT sind noch höhere Eigenschaftswerte erreichbar (E- Modul: 410 GPa bis 4150 GPa vs. Graphit: 1000 GPa, SWCNT: Wärmeleitfähigkeit ca. 6000 W*(m*K)-1). Allerdings zeigt sich hier ein schlechteres Leistungs-/Kosten-Verhältnis im Vergleich zu MWCNT. Die Zylinderdurchmesser von MWCNT liegen typischerweise im Bereich von 1 nm bis 100 nm, bevorzugt von 5 bis 50 nm, mit einer Länge von 500 nm bis 1000 $\mu$m.

Gemäß weiteren Ausführungsvarianten kann der dritte Füllstoff MWCNT umfassen und gleichzeitig der zweite und/oder erste Füllstoff Industrieruß umfassen oder aus diesem bestehen, da hier ebenfalls eine Verbesserung der Wärmeleitfähigkeit (z. B. bis zu 200 W*(m*K)-1) erreicht werden kann. Da der Einsatz von beispielhaft Industrieruß eine deutlich geringere Reißfestigkeit mit Werten von < 0,4 GPa aufweist, ist eine Kombination aus beiden oder weiteren Füllstoffen möglich und kann zu einer Verbesserung der Gesamtsplitausbeute und zu einer Verbesserung der Gesamtkosten im Splitting-Verfahren führt.

20 Hierbei liegen die mittleren Durchmesser der Rußpartikel (Carbon Black) im Bereich von 5 nm bis 500 nm, bevorzugt von 20 nm bis 200 nm, besonders bevorzugt von 40 nm bis 100 nm.

Weiterhin können die Füllstoffe Kieselsäure, beispielsweise pyrogene Kieselsäure, umfassen oder aus dieser bestehen. 25 Zusätzlich oder alternativ kann ein weiterer Füllstoff umfassend oder bestehend aus Kieselsäure im Polymer-Hybrid-Material vorgesehen sein.

Pyrogene Kieselsäure kann ein dreidimensionales Netzwerk ausbilden und dadurch zur Verbesserung der mechanischen30 Stabilität beitragen. Somit kann ein solcher Füllstoff der gezielten Einstellung der mechanischen Eigenschaften des Polymer-Hybrid-Materials dienen. Einer oder mehrere der genannten Füllstoffe (erster, zweiter, dritter Füllstoff) können aus demselben Material bestehen, sofern dies mit der ihnen zugeschriebenen Funktion vereinbar ist. Beispielsweise kann sowohl der erste als auch der dritte Füllstoff Aluminium umfassen oder aus Aluminium bestehen. Aluminium lässt sich wie oben beschrieben sowohl zur Generierung von Kavitäten und damit zur Beschleunigung des Ablösens des Polymer-Hybrid-Materials vom Festkörper- Teilstück nutzen als auch zur Erhöhung der Temperaturleitfähigkeit. Eine derartige Ausgestaltung vereinfacht den Herstellungsprozess, da es ausreichend sein kann, nur einen oder zwei Füllstoffe hinzuzufügen, um alle Funktionen zu erfüllen.

Erster und zweiter sowie ggf. dritter Füllstoff können auch aus unterschiedlichen Materialien bestehen. Dadurch wird eine individuelle und damit bessere Anpassung des Füllstoffs an die gewünschte Funktion ermöglicht.

Eine erfindungsgemäße Folie umfasst ein Polymer-Hybrid-Material, wie obenstehend beschrieben. Die Folie kann eine Dicke von beispielsweise 0,5 bis 5 mm aufweisen.

Auf zumindest diese Oberfläche wird ein erfindungsgemäßes Polymer-Hybrid-Material oder eine erfindungsgemäße Folie aufgebracht, so dass eine entsprechende Verbundstruktur resultiert. Das aufgebrachte Polymer-Hybrid-Material bzw. die aufgebrachte Folie werden im Folgenden auch als Aufnahmeschicht bezeichnet. Die Dicke einer solchen Aufnahmeschicht kann beispielsweise zwischen 0,5 mm und 5 mm, insbesondere zwischen 1mm und 3mm, liegen. Optional kann das Polymer-Hybrid-Material oder die Folie auch auf mehrere freiliegende Oberflächen, insbesondere auf parallel zueinander angeordnete Oberflächen aufgebracht werden.

Die thermische Beaufschlagung stellt bevorzugt ein Abkühlen der Aufnahmeschicht unter die Umgebungstemperatur und bevorzugt unter 10 °C und besondere bevorzugt unter 0 °C und weiter bevorzugt unter -10 °C oder unter -40 °C dar.

Die Abkühlung der Aufnahmeschicht erfolgt höchst bevorzugt derart, dass zumindest ein Teil der Aufnahmeschicht einen Glasübergang vollzieht. Die Abkühlung kann hierbei eine Abkühlung auf unter -100 °C sein, die z. B. mittels flüssigen Stickstoffs bewirkbar ist. Diese Ausführungsform ist vorteilhaft, da sich die Aufnahmeschicht in Abhängigkeit von der Temperaturveränderung zusammenzieht und/oder einen Glasübergang erfährt und die dabei entstehenden Kräfte auf das Festkörper-Ausgangsmaterial übertragen werden, wodurch mechanische Spannungen in dem Festkörper erzeugbar sind, die zum Auslösen eines Risses und/oder zur Rissausbreitung führen, wobei sich der Riss zunächst entlang der ersten Ablöseebene zum Abspalten der Festkörperschicht ausbreitet.

In einem weiteren Schritt wird das Polymer-Hybrid-Material oder die Folie vom Festkörper-Teilstück, beispielsweise durch eine chemische Reaktion, ein physikalischer Ablösevorgang und/oder mechanisches Abtragen, entfernt.

Der Ablösevorgang des Polymer-Hybrid-Materials vom Festkörper-Teilstück kann bei moderater Umgebungstemperatur, z. B. im Bereich von 20 °C bis 30 °C stattfinden, bevorzugt im höheren Temperaturbereich von 30 °C bis 95 °C, z. B. von 50 °C bis 90 °C, oder aber beispielsweise auch in einem unteren Temperaturbereich zwischen 1 °C und 19 °C.

Der erhöhte Temperaturbereich kann eine Verkürzung einer chemischen Ablösereaktion aufgrund einer Erhöhung der Reaktionsgeschwindigkeit ermöglichen, z. B. im Falle der Verwendung einer Opferschicht zwischen dem Polymer-Hybrid-Material und dem Festkörper. Im Falle der Verwendung einer Opferschicht kann das Ablösen in wässriger Lösung erfolgen, vorteilhaft bei einem pH-Wert im Bereich von 2 - 6. Gemäß verschiedenen Ausführungsvarianten kann beispielhaft der Ablösevorgang in Form einer Behandlung mit einer Lösung aus einem geeigneten apolaren Lösungsmittel erfolgen, wobei moderate Umgebungstemperaturen im Bereich von 1 °C bis 50 °C bevorzugt und von 20°C bis 40°C besonders bevorzugt sind.

Ein besonderer Vorteil hierbei ist das Ablösen ohne eine Temperatureinwirkung auf die Folie. Hierbei können vorteilhaft aliphatische und aromatische Kohlenwasserstoffe wie z. B. Toluol, n-Pentan, n-Hexan, aber auch halogenierte Lösungsmittel, wie z. B. Tetrachlorkohlenstoff, angewendet werden. Hierbei können zusätzliche Kräfte in das abzulösende Polymer-Hybrid-Material und die Grenzfläche zum Festkörper-Teilstück eingebracht werden, da durch eine Lösungsmittelbehandlung eine sehr starke reversible Quellung des Polymers-Hybriden-Materials auftreten kann, wodurch das Ablösen insgesamt vereinfacht wird.

Gemäß weiteren Ausführungsvarianten kann eine Kombination mit dem oben beschriebenen Ablösemechanismus der Opferschicht und der Behandlung mit einem geeigneten apolaren Lösungsmittel erfolgen - ebenfalls ohne Temperatureinwirkung auf die Folie.

Weiterhin bezieht sich die vorliegende Erfindung auf eine Vorrichtung zum Erzeugen von Modifikationen in einem Festkörper gemäß Anspruch 11, wobei durch die Modifikationen ein Rissführungsbereich zum Führen eines Risses zum Abtrennen eines Festkörperanteils, insbesondere einer Festkörperschicht, von dem Festkörper vorgegeben wird. Erfindungsgemäß umfasst die Vorrichtung bevorzugt mindestens eine Aufnahmeeinrichtung zum Aufnehmen und Bewegen von mindestens einem Festkörper, eine Laserbeaufschlagungseinrichtung zum Emittieren von einer Vielzahl an Laserstrahlen nacheinander, wobei die Laserstrahlen fokussiert werden und in dem Fokuspunkt eine Modifikation erzeugen, eine Steuerungseinrichtung, wobei die Steuerungseinrichtung Daten zu mindestens einem ersten Parameter und zu einem zweiten Parameter verarbeitet und in Abhängigkeit dieser Daten die Laserbeaufschlagungseinrichtung kontinuierlich, insbesondere für jede Modifikation, einstellt.

Gegenüber der klassische Anordnung für einen Autofokus bestehend aus Abstandssensor und Objektivversteller, weist die erfindungsgemäße Vorrichtung bevorzugt eine Steuerung auf, die Korrekturen in Abhängigkeit von Nutzereingaben, Sensorsignalen und/oder externen Datenquellen vornimmt.

Eine Schwierigkeit liegt in der Maschinenintegration. Wenn keine korrigierte Echtzeitregelung möglich ist, synchronisiert der Laserkopf bzw. die Laserbeaufschlagungseinrichtung bevorzugt mit einer Positioniereinheit bzw. der Aufnahmeeinrichtung. Die Karte der Korrekturfaktoren bzw. die Daten bzgl. der Parameter aus der bevorzugt zuvor bewirkten oder aktuell erfolgenden Charakterisierung wird bevorzugt mit dem Werkstück bzw. dem Festkörper zur Maschine registriert und wird dann ortsabhängig ausgegeben. Aufgrund der Dynamik der Einstellvorgänge bzw. Manipulation bzw. Fokussiervorgänge, ist eine Steuerung aus der Maschinensoftware aufgrund der Zugriffszeiten nicht immer geeignet. Es wird daher bevorzugt ein Controller insbesondere die Steuerungseinrichtung eingesetzt, der geeignete LookUp Tabellen bzw. Daten, welche die Parameter repräsentieren, für den schnellen Zugriff, insbesondere vor Beginn der Bearbeitung, lädt.

Die erfindungsgemäße Vorrichtung ermöglicht somit erstmals die planare Mikrobearbeitung von Festkörpern mit Mehrphotonenabsorption im Volumen. Die planare Mikrobearbeitung ermöglicht erst die Bearbeitung von Subtraten bzw. Festkörpern mit größerem Durchmesser, die nicht $\mu$m-genau/verkippungsfrei platziert werden können. Diese Bearbeitung wird nicht nur beim Abtrennen von Festkörperanteilen bzw. beim Wafering, sondern insbesondere auch beim lasergestützten Abdünnen von Wafern relevant. Sollen dünne Halbleiterscheiben bzw. Festkörperanteile effizient erzeugt werden, so ist das planare Laserspalten essentiell, da dünne Scheiben nur wenig Planarisierungsreserve zulassen.

Gemäß einer bevorzugten Ausführungsform der vorliegenden Erfindung ist ein erster Parameter die mittlere Brechzahl des Materials des Festkörpers oder die Brechzahl des Materials des Festkörpers ist in dem Bereich des Festkörpers, der zur Erzeugung einer definierten Modifikation von Laserstrahlen zu durchqueren ist, und ein zweiter Parameter ist die Bearbeitungstiefe in dem Bereich des Festkörpers, der zur Erzeugung einer definierten Modifikation von Laserstrahlen zu durchqueren ist. Diese Ausführungsform ist vorteilhaft, da die Parameter Bearbeitungstiefe und Brechzahl erhebliche Auswirkungen auf die Präzision des erzeugten Fokuspunkts haben.

Ein Distanzsensormittel zur Bestimmung eines Verkippungsparameters ist gemäß einer weiteren bevorzugten Ausführungsform der vorliegenden Erfindung vorgesehen, wobei der Verkippungsparameter eine Verkippung des Festkörpers gegenüber der Laserbeaufschlagungseinrichtung repräsentiert, wobei das Distanzsensormittel Distanzdaten ausgibt, wobei die Distanzdaten ebenfalls von der Steuerungseinrichtung zum Einstellen der Laserbeaufschlagungseinrichtung verarbeitet werden.

Eine Antriebseinrichtung zum Bewegen der Aufnahmeeinrichtung ist gemäß einer weiteren bevorzugten Ausführungsform der vorliegenden Erfindung vorgesehen, wobei die Steuerungseinrichtung die Bewegungsgeschwindigkeit der Aufnahmeeinrichtung in Abhängigkeit von den verarbeiteten Parametern einstellt.

Die Definitionen der Begriffe "Bow", "Warp", "TTV" und "TIR" erfolgt im Rahmen der vorliegenden Erfindung gemäß den Definitionen, wie sie dem Fachmann nach SEMI-Norm bekannt sind und beispielsweise in http://www.wafertech.co.uk/_downloads/Wafer-Flatness.pdf angegeben sind.

Die Verwendung der Wörter "im Wesentlichen" definiert bevorzugt in allen Fällen, in denen diese Wörter im Rahmen der vorliegenden Erfindung verwendet werden eine Abweichung im Bereich von 1%-30%, insbesondere von 1%-20%, insbesondere von 1%-10%, insbesondere von 1%-5%, insbesondere von 1%-2%, von der Festlegung, die ohne die Verwendung dieser Wörter gegeben wäre. Einzelne oder alle Darstellungen der im Nachfolgenden beschriebenen Figuren sind bevorzugt als Konstruktionszeichnungen anzusehen, d.h. die sich aus der bzw. den Figuren ergebenden Abmessungen, Proportionen, Funktionszusammenhänge und/oder Anordnungen entsprechen bevorzugt genau oder bevorzugt im Wesentlichen denen der erfindungsgemäßen Vorrichtung bzw. des erfindungsgemäßen Produkts.

Gemäß einer weiteren bevorzugten Ausführungsform der vorliegenden Erfindung werden die Modifikationen nacheinander in mindestens einer Zeile oder Reihe oder Linie erzeugt, wobei die in einer Zeile oder Reihe oder Linie erzeugten Modifikationen bevorzugt in einem Abstand X und mit einer Höhe H erzeugt werden, damit ein sich zwischen zwei aufeinander folgenden Modifikationen ausbreitender Riss, insbesondere in Kristallgitterrichtung ausbreitender Riss, dessen Rissausbreitungsrichtung in einem Winkel W gegenüber der Ablöseebene ausgerichtet ist, die beiden Modifikationen miteinander verbindet. Der Winkel W liegt hierbei bevorzugt zwischen 2° und 6°, insbesondere bei 4°. Bevorzugt breitet sich der Riss von einem Bereich einer ersten Modifikation unterhalb des Zentrums der ersten Modifikation hin zu einem Bereich einer zweiten Modifikation oberhalb des Zentrums der zweiten Modifikation hin aus. Der hierbei wesentliche Zusammenhang ist daher, dass die Größe der Modifikation in Abhängigkeit des Abstands der Modifikationen und des Winkels W verändert werden kann bzw. muss.

Gemäß einer weiteren bevorzugten Ausführungsform der vorliegenden Erfindung werden in einem ersten Schritt die Modifikationen auf einer Linie und bevorzugt im gleichen Abstand zueinander erzeugt. Weiterhin ist vorstellbar dass eine Vielzahl dieser im ersten Schritt erzeugten Linien erzeugt werden. Diese ersten Linien werden besonders bevorzugt parallel zur Rissausbreitungsrichtung uns bevorzugt geradlinig oder kreisbogenförmig, insbesondere in derselben Ebene, erzeugt. Nach der Erzeugung dieser ersten Linien werden bevorzugt zweite Linien zum Auslösen und/oder Treiben von bevorzugt unterkritischen Rissen erzeugt. Diese zweiten Linien werden ebenfalls bevorzugt geradlinig erzeugt. Besonders bevorzugt sind die zweiten Linien gegenüber den ersten Linien geneigt, insbesondere orthogonal ausgerichtet. Die zweiten Linien erstrecken sich bevorzugt in derselben Ebene wie die ersten Linien oder besonders bevorzugt in einer Ebene die parallel zu der Ebene ist, in der sich die ersten Linien erstrecken. Anschließende werden bevorzugt dritte Linien erzeugt zum Verbinden der unterkritischen Risse erzeugt.

Hierbei kann die Steuerungseinrichtung gemäß einer bevorzugten Ausführungsform der vorliegenden Erfindung Distanzdaten sowie Parameter jeweils weiterer Sensormittel zur Einstellung der Laserbeaufschlagungseinrichtung in einer Weise verarbeiten, dass für die ortsabhängige Steuerung der Laserbeaufschlagungseinrichtung an den Orten, wo keine ortsabhängigen Messdaten vorliegen, ortsabhängige Steuerungsanweisungen für die Laserbeaufschlagungseinrichtung aus den vorliegenden ortsabhängigen Messdaten des Distanzsensors und weiterer möglicher Sensormittel nach einer Rechenvorschrift errechnet oder zwischen den ortsabhängigen Messdaten interpoliert. So können zum Beispiel Distanzdaten und Sensordaten jeweils weiterer Sensormittel nur an einer geringen Zahl an Punkten in kurzer Zeit in einem groben Raster gemessen werden und die übrigen Positionen auf dem Werkstück interpoliert werden. Idealerweise wird das Ziel angestrebt, das Werkstück mit einer möglichst geringen Zahl an Messpunkten zu charakterisieren um dann die Laserbeaufschlagung durchzuführen. Hierbei kann diese Interpolation in der Steuerungseinrichtung der Laserbeaufschlagungseinrichtung während der Beaufschlagung stattfinden, oder es kann eine ortsabhängige Bearbeitungsanweisung mit beliebiger örtlicher Auflösung auf einer weiteren Datenverarbeitungseinrichtung erzeugt und dann an die Steuerungseinrichtung übergeben werden. Diese Ausführungsform der Erfindung ist besonders vorteilhaft, da nicht für jeden zu beaufschlagenden Ort des zu beaufschlagenden Werkstücks Messdaten erfasst werden müssen, sondern aus wenigen Messdaten, die in kürzerer Zeit erfasst werden können, eine jeweils höhere Dichte an Bearbeitungsanweisungen für die Laserbeaufschlagungseinrichtung erzeugt werden können. Dies erhöht die Bearbeitungsgeschwindigkeit am Werkstück insgesamt, da die Messzeit hierdurch reduziert werden kann.

Weitere Vorteile, Ziele und Eigenschaften vorliegender Erfindung werden anhand nachfolgender Beschreibung anliegender Zeichnungen erläutert, in welchen beispielhaft erfindungsgemäße Vorrichtungen dargestellt sind. Elemente der erfindungsgemäßen Vorrichtungen und Verfahren, welche in den Figuren wenigstens im Wesentlichen hinsichtlich ihrer Funktion übereinstimmen, können hierbei mit gleichen Bezugszeichen gekennzeichnet sein, wobei diese Bauteile bzw. Elemente nicht in allen Figuren beziffert oder erläutert sein müssen. Nachfolgend wird die Erfindung rein beispielhaft anhand der beigefügten Figuren beschrieben.

Darin zeigen:

Fig. 1 ein Beispiel einer erfindungsgemäßen Laserbeaufschlagungs-einrichtung;
Fig. 2a ein Beispiel einer erfindungsgemäßen Vorrichtung;
Fig. 2b die Beaufschlagung einer an dem Festkörper angeordneten Polymerschicht mit einem Funktionsfluid;
Fig. 3a eine exemplarische Darstellung eines Oberflächenprofils eines Festkörpers und der Brechzahlen dieses Oberflächenprofils;
Fig. 3b mehrere Darstellungen von Oberflächenprofilen;
Fig. 4a mehrere Darstellungen der Veränderungen von Regelpositionen des Laserkopfes; und
Fig. 4b zwei Verläufe, die Profile unterschiedlicher Modifikationsverteilungen repräsentieren und
Fig. 5a einen schematischen Aufbau eines Raman-Instruments, wie es bevorzugt erfindungsgemäß verwendet wird, insbesondere wie es bevorzugt Bestandteil der erfindungsgemäßen Vorrichtung ist;
Fig. 5b verschiedene exemplarische Schwingungszustände der Gitterschwingungen von SiC,
Fig. 6a und 6b zwei Schaubilder, welche Dotierkonzentrationen in einem Festkörper darstellen;
Fig. 7a einen erfindungsgemäßen Feedforwardprozess und
Fig. 7b einen erfindungsgemäßen Feedbackprozess,

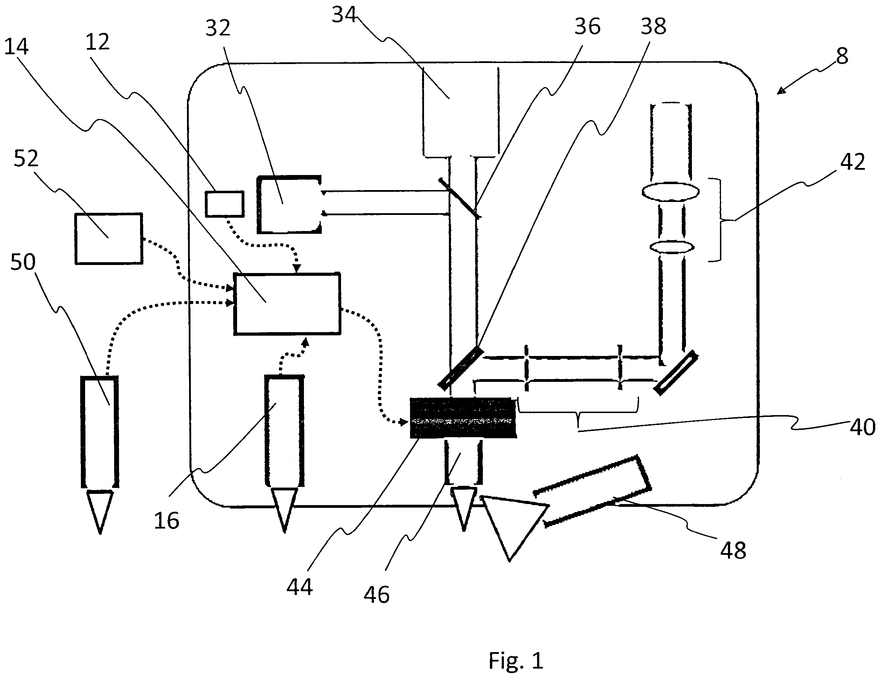

Fig. 1 zeigt einen erfindungsgemäße Laserbeaufschlagungseinrichtung 8, wie sie bevorzugt in dem erfindungsgemäßen Verfahren und der erfindungsgemäßen Vorrichtung 30 zum Erzeugen von Modifikationen 2 in einem Festkörper 1 vorgesehen ist.

Die Laserbeaufschlagungseinrichtung 8 weist hierbei mindestens eine Laserstrahlenquelle 32, insbesondere mit Fokusmarkierung, auf. Bei der Laserstrahlenquelle 32 kann es sich somit bevorzugt konkret um eine koaxiale Lichtquelle mit Fokusmarkierung handeln. Die durch die Laserstrahlenquelle 32 erzeugten Lichtstrahlen 10 werden bevorzugt auf einem vorbestimmten Weg von der Laserstrahlenquelle 32 zu einer Fokuseinrichtung 44 bzw. einer Einstelleinrichtung 44 zum Einstellen einer Fokusgröße und einer Fokusposition in dem Festkörper 1 geleitet. Bei der Einstelleinrichtung 44 kann es sich hierbei bevorzugt um eine Feinfokussiereinrichtung, insbesondere in Z-Richtung bzw. in Laserstrahlverlaufsrichtung, handeln. Bevorzugt kann die Einstelleinrichtung 44 als Piezofeinfokussiereinrichtung ausgebildet sein. Die durch die Einstelleinrichtung 44 hindurch gegangenen Laserstrahlen 10 passieren bevorzugt ein Mikroskop mit langem Arbeitsabstand 46. Besonders bevorzugt wird durch das Mikroskop mit dem langen Arbeitsabstand 46 und die Einstelleinrichtung 44 die Laserstrahlung derart angepasst bzw. eingestellt bzw. modifiziert, dass die Modifikation 2 an der vordefinierten Stelle erzeugt wird. Es ist hierbei denkbar, dass die Modifikation 2 an einer Stelle erzeugt wird, die z.B. weniger als $5\,\mu$m und bevorzugt weniger als $2\,\mu$m und besonders bevorzugt weniger als $1\,\mu$m von der vordefinierten Stelle abweicht bzw. dazu beabstandet ist. Die Einstelleinrichtung 44 wird bevorzugt mittels einer Steuereinrichtung 14 angesteuert, wobei die Steuereinrichtung 14 bevorzugt die Relativposition und Orientierung des Festkörpers 1 gegenüber der Laserbeaufschlagungseinrichtung 8 oder den Abstand des aktuellen Oberflächenanteils, in den Laserstrahlung eingeleitet werden soll, zu der Laserbeaufschlagungseinrichtung 8 sowie die lokale Brechzahl oder mittlere Brechzahl des Festkörpermaterials und die Bearbeitungstiefe des Festkörpers 1 an der jeweiligen Stelle für die Einstellung der Laserbeaufschlagungseinrichtung 8, insbesondere zumindest der Einstelleinrichtung 44, berechnet bzw. bestimmt bzw. verwendet. Die Steuerungseinrichtung 14 erfasst bzw. empfängt gemäß der Erfindung die erforderlichen Daten in Echtzeit durch entsprechende und damit kommunizierend verbundene Sensoreinrichtungen bzw. Sensormittel.

Alternativ ist jedoch ebenfalls denkbar, dass z.B. für einen oder beide der Parameter Brechzahl und Bearbeitungstiefe vor Bearbeitungsbeginn eine Analyse der Oberfläche vorgenommen bzw. durchgeführt wird, über welche die Laserstrahlen 10 in den Festkörper 1 zur Erzeugung der Modifikationen 2 eindringen. Die Parameter werden alternativ gemäß der Erfindung dann in Form entsprechender ortsabhängiger Daten in einer Speichereinrichtung bzw. einem Datenspeicher 12 vorgehalten bzw. darin eingelesen. Der Datenspeicher 12 kann hierbei als Wechselmedium, insbesondere eine Speicherkarte, oder als fest verbauter Speicher ein Teil der Laserbeaufschlagungseinrichtung 8 sein.

Alternativ ist jedoch ebenfalls denkbar, dass der Datenspeicher 12 außerhalb der Laserbeaufschlagungseinrichtung 8 angeordnet ist und zumindest zeitweise kommunizierend mit der Laserbeaufschlagungseinrichtung 8 verbindbar ist. Zusätzlich oder alternativ kann der Steuereinrichtung 14 durch einen Nutzer 52 Arbeitsabläufe oder Änderungen im Arbeitsablauf vorgegeben werden. Ferner ist denkbar, dass der Datenspeicher 12 als Bestandteil der Steuerungseinrichtung 14 ausgebildet ist. Zusätzlich oder alternativ können mittels einer Sensoreinrichtung 16 Distanzdaten zum Abstand zwischen vorgegebenen Oberflächenpunkten des Festkörpers 1 und der Laserbeaufschlagungseinrichtung 8 erfasst werden. Diese Distanzdaten werden bevorzugt ebenfalls der Steuerungseinrichtung 14 zur Verarbeitung bereitgestellt.

Weiterhin ist vorstellbar, dass die Laserstrahlbeaufschlagungseinrichtung 8 eine Kamera 34, insbesondere eine koaxiale Fokuskamera, aufweist. Die Kamera 34 ist bevorzugt in Richtung des Strahlengangs der aus der Laserbeaufschlagungseinrichtung 8 austretenden Laserstrahlen 10 angeordnet. Es ist hierbei denkbar, dass ein optisches Element 36, insbesondere ein teilweise transparenter Spiegel in dem optischen Feld der Kamera 34 angeordnet ist. Bevorzugt wird durch das optische Element 34 die Laserstrahlung 10 in das optische Feld der Kamera eingeschleust.

Weiterhin ist vorstellbar, dass ein weiteres optisches Element 38 bzw. ein diffraktives optisches Element, insbesondere ein Strahlteiler 38, vorgesehen ist. Durch den Strahlteiler 38 kann hierbei ein Teil des Laserstrahls 10 von dem Hauptstrahl ausgeleitet bzw. abgetrennt werden. Ferner kann der abgetrennte bzw. ausgeleitete Anteil der Laserstrahlung durch eine optionale sphärische Aberrationskompensation 40 und/oder durch eine optionale Strahlerweiterung 42 bzw. Strahlaufweitung modifiziert werden.

Ferner kennzeichnet das Bezugszeichen 48 eine bevorzugt vorgesehenen Fluidbereitstellungseinrichtung 48, insbesondere zum Bereitstellen eines Kühlfluides. Bevorzugt kann mittels der Fluidbereitstellungseinrichtung 48 eine Temperierung, insbesondere Abkühlung, des Festkörpers 1 und/oder des Mikroskops, bewirkt werden.

Das Bezugszeichen 50 kennzeichnet ein Brechzahlbestimmungsmittel, das bevorzugt auch transparente und reflektierende Oberflächen analysieren kann. Bevorzugt erfolgt die Brechzahlbestimmung mit dem Brechzahlbestimmungsmittel 50 im Vorfeld der Modifikationserzeugung. Es ist hierbei alternativ denkbar, dass die Brechzahlbestimmung an einer anderen Anlage durchgeführt wird und die erfassten Daten der vorliegenden Laserbeaufschlagungseinrichtung 8 mittels Datentransfer zugeführt wird.

Die in Fig. 1 dargestellten Punktlinien mit einem Pfeilende kennzeichnen hierbei bevorzugt Daten und/oder Signal Übertragungen.

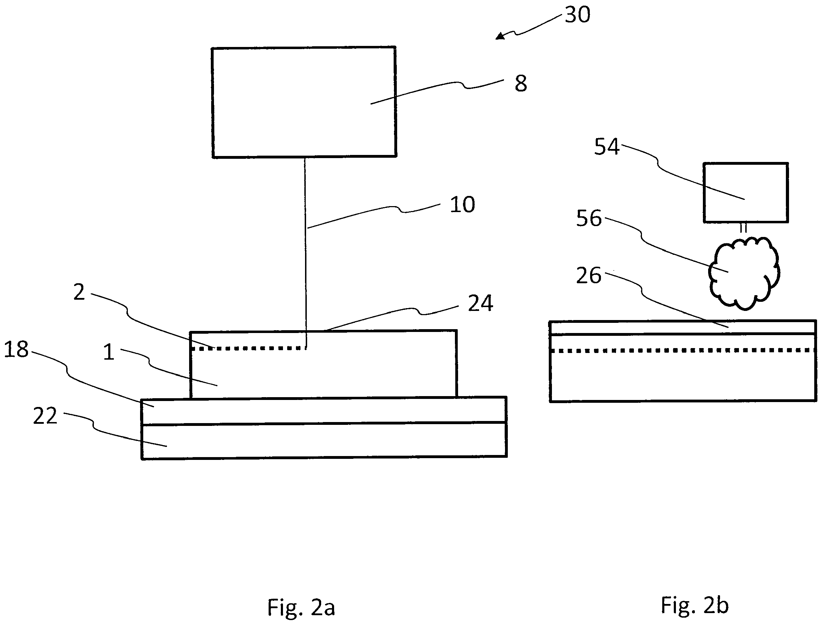

Fig. 2a zeigt schematisch eine bevorzugte Anordnung der Vorrichtungskomponenten Laserbeaufschlagungseinrichtung 8, Aufnahmeeinrichtung 18 und Antriebs- bzw. Verfahreinrichtung 22 der Vorrichtung 30. Es ist ersichtlich, dass der Festkörper 1 gemäß dieser Anordnung bevorzugt zwischen der Aufnahmeeinrichtung 18 und der Laserbeaufschlagungseinrichtung 8 angeordnet ist. Bevorzugt ist der Festkörper 1 an der Aufnahmeeinrichtung 18 angeklebt, wobei auch denkbar ist, dass er daran angepresst wird.

Fig. 2b zeigt eine Anordnung nach der Erzeugung der Modifikationen 2 bzw. nach der vollständigen Erzeugung des Rissführungsbereichs 4. An der Oberfläche 24 des Festkörpers 1, über welche die Laserstrahlen 10 in den Festkörper 1 eingedrungen sind, ist gemäß dieser Darstellung eine Aufnahmeschicht bzw. Polymerschicht 26 angeordnet bzw. ausgebildet. Weiterhin wird durch die Einrichtung 54 eine Funktionsfluidquelle gekennzeichnet, die das Funktionsfluid 56 ausgibt. Bei dem Funktionsfluid 56 handelt es sich bevorzugt um flüssigen Stickstoff. Durch das Funktionsfluid 56 erfolgt somit eine Abkühlung der Aufnahmeschicht 26 auf eine Temperatur unterhalb von 20°C, insbesondere auf eine Temperatur unterhalb von 10°C oder auf eine Temperatur unterhalb von 0°C oder auf eine Temperatur unterhalb der Glasübergangstemperatur des Polymermaterials der Aufnahmeschicht 26. Durch die Abkühlung der Aufnahmeschicht 26 werden hohe mechanische Spannungen erzeugt, durch die eine Rissausbreitung entlang dem Rissführungsbereich 4 erfolgt.

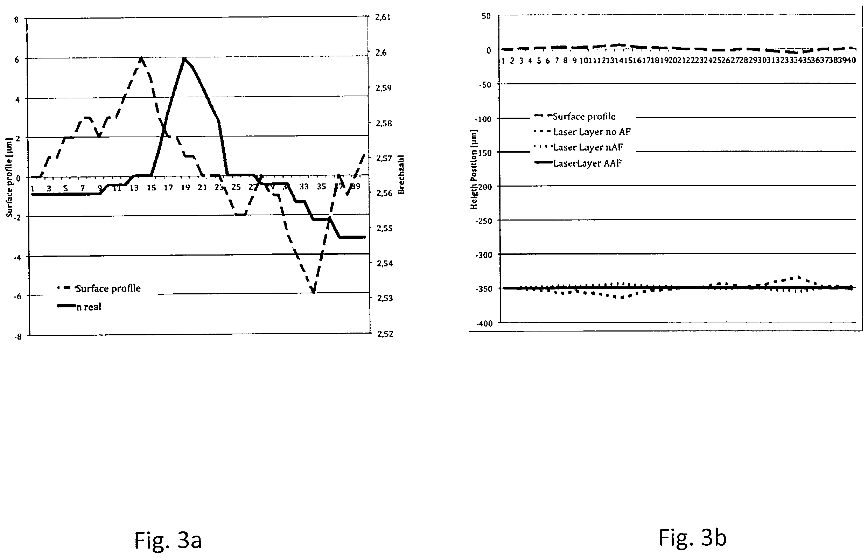

Fig. 3a zeigt rein exemplarisch den Zusammenhang zwischen einem Oberflächenprofil eines Festkörpers 1 und der Brechzahl des Festkörpermaterials. Die auf der horizontalen Achse angegebenen Werte liegen in der Einheit $\mu$m vor.

Fig. 3b zeigt exemplarische Abweichungen des zu lasernden Materials (Oberflächenprofil und lateraler Brechzahlverlauf) sowie Laserfokuslage (no AF: ohne Autofokus wird Oberflächenprofil invers um Brechzahl verstärkt in das Material geschrieben, ein Standard-AF kehrt diese Inversion um, so dass das Oberflächenprofil n-fach verstärkt übertragen wird. nAF: berücksichtigt die Substratbrechzahl bzw. Brechzahl als festen Faktor, so dass damit das Oberflächenprofil 1:1 in das Material übertragen wird. AAF: die gewünschte Advanced Autofokusfunktion kann mit Kenntnis der mittleren Substratbrechzahl und der Zieltiefe eine exakt horizontal Ebene in das Material schreiben).

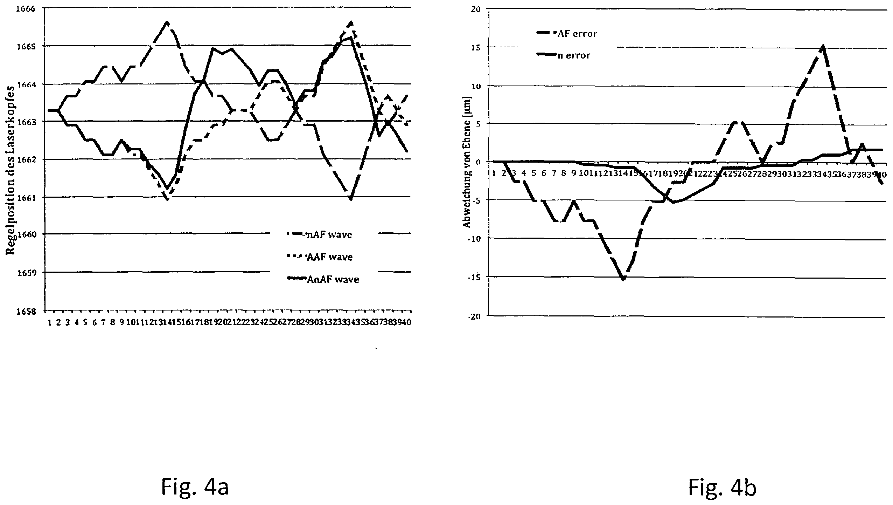

Fig. 4a zeigt rein exemplarisch verschiedene Regelpositionen des Laserfokus. Die auf der horizontalen Achse angegebenen Werte liegen in der Einheit $\mu$m vor. Somit kann die Waveform als Regeleingangsgröße für die Position des Laserkopfes in verschiedenen Fällen bestimmt werden:

nAF (n-aware AF): die Autofokusführungsgröße der Oberfläche um die mittlere Substratbrechzahl (n) zu korrigieren. Damit kann die Oberflächen-Abweichung 1:1 ins Volumen übertragen werden. Der abzuspaltende Wafer wird somit theoretisch keine Dickenschwankungen (TTV) aufweisen. Jedoch bleibt die Topographie und somit die schlechte Planarität sowohl für den Wafer als auch den Verbleibenden Ingot erhalten. AAF (advanced AF): die Autofokusführungsgröße der Oberfläche mit Kenntnis der mittlere Substratbrechzahl und der Ausgleichsebene der Oberfläche zu korrigieren. Damit gelingt bei homogenen Proben ohne Abweichungen von der mittleren Brechzahl eine plane Laserebene, die mit preiswertem Polierschritt den Halbleiterkristall sehr plan für weitere Splits vorbereitet. Hingegen wird der abgespaltene Wafer direkt nach dem Split einseitig plan aber höherer Dickenabweichung aufweisen.

AnAF (Advanced n-aware AF): die Autofokusführungsgröße der Oberfläche mit Kenntnis der lokalen Substratbrechzahl und der Ausgleichsebene der Oberfläche zu korrigieren. Damit gelingt auch bei inhomogenen Proben mit Vorwissen eine plane Laserebene, die mit preiswertem Polierschritt den Halbleiterkristall sehr plan für weitere Splits vorbereitet.

Die vorliegende Erfindung bezieht sich somit auf ein Verfahren zur Erzeugung von Modifikationen in einem Festkörper, wobei durch die Modifikationen ein Rissführungsbereich zum Führen eines Risses zum Abtrennen eines Festkörperanteils, insbesondere einer Festkörperschicht, von dem Festkörper vorgegeben wird. Das erfindungsgemäße Verfahren umfasst dabei bevorzugt mindestens die Schritte:

Bewegen des Festkörpers relativ zu einer Laserbeaufschlagungseinrichtung, nacheinander erzeugen von einer Vielzahl an Laserstrahlen mittels der Laserbeaufschlagungseinrichtung zum Erzeugen von jeweils mindestens einer Modifikation, wobei die Laserbeaufschlagungseinrichtung zur definierten Fokussierung der Laserstrahlen kontinuierlich in Abhängigkeit von einer Vielzahl an Parametern, insbesondere mindestens zwei Parametern, eingestellt wird. Bevorzugt wird durch das erfindungsgemäße Verfahren ein planarer Mikrofokus für Mehrphotonen-Materialbearbeitung im Volumen ermöglicht.

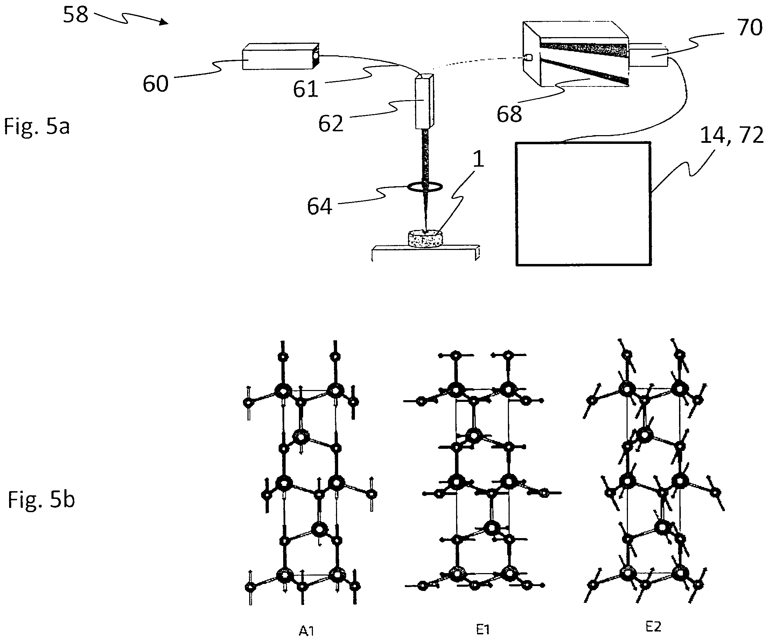

Fig. 5a zeigt ein Raman-Instru 58ment. Das hier gezeigte Raman-Instrument 58 weist einen Laser 60 zum Emittieren von Strahlung auf. Die Strahlung wird bevorzugt mittels mindestens einer optischen Faser 61 für eine Anregung bevorzugt einer Optik zugeführt und von dieser Optik, insbesondere Linse 64, bevorzugt fokussiert, insbesondere in den Festkörper fokussiert. Diese Strahlung wird zumindest teilweise gestreut, wobei bevorzugt mittels einer Filtereinrichtung bzw. Anregungsfilter 62 Lichtanteile herausgefiltert werden, welche dieselbe Wellenlänge wie die vom Laser emittierte Strahlung aufweisen. Die sonstigen Strahlungsanteile werden dann einem Spektrographen 68 zugeführt und mittels einer Kameraeinrichtung, insbesondere einem CCD-Detektor 70 erfasst und von einer Steuerungseinrichtung 14, 72, insbesondere einem Computer, ausgewertet bzw. aufbereitet.

Es werden somit bevorzugt Atomschwingungen im Kristall durch einen bevorzugt externen oder besonders bevorzugt weiteren Laser angeregt. Diese Schwingungen werden durch Lichtstreuung an Kristallatomen erzeugt, was zu beobachtbarem gestreutem Licht führt, was eine um den Betrag der Schwingungsenergie veränderte Photonenenergie aufweist. Bei mehreren anregbaren Schwingungen treten auch mehrere Peaks im Spektrum des gestreuten Lichts auf. Mit einem Spektrometer (Gitterspektrometer) kann dann das entstandene Raman-Streuungsspektrum näher untersucht werden (sog. RamanSpektroskopie). Bei dieser Methode sind den einzelnen Raman-Linien in ihrer Form die lokalen Bedingungen im Kristall aufgeprägt und durch eine Analyse der Form der Raman-Linie kann auf den Dotiergrad rückgeschlossen werden.

Fig. 5b zeigt, wie mögliche Gitterschwingungen in SiC aussehen, wobei diese Moden durch Kristallsymmetrie und Richtungen vorgegeben sind und auch gleichzeitig angeregt sein können. Die gezeigten Ansichten weisen eine Erstreckung entlang der Kristallachse A auf. Hierbei sind Schwingungen der Atome nur in bestimmten Richtungen möglich, wobei die Richtungen durch die Symmetrie des Kristalls vorgegeben sind.

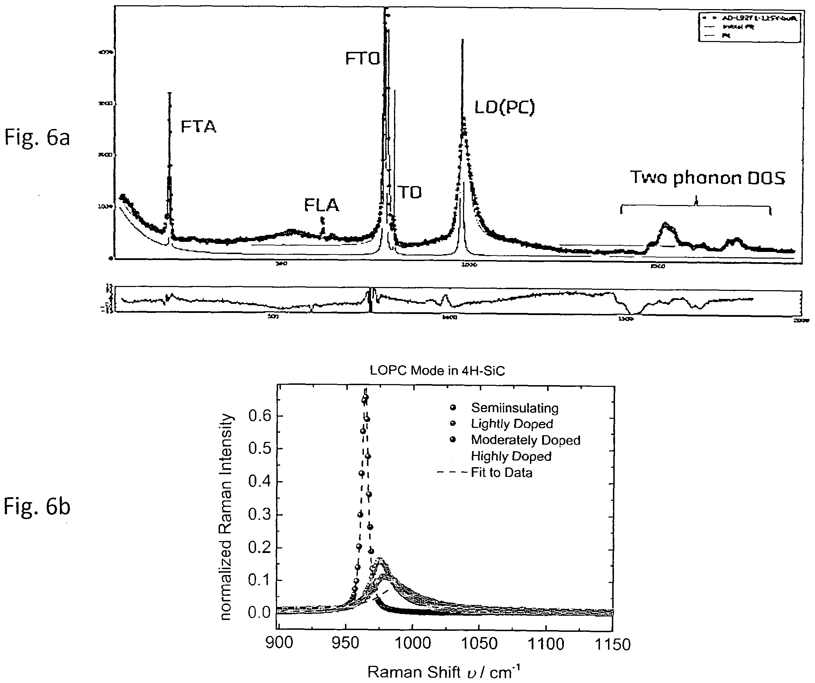

Fig. 6a zeigt einen Ausschnitt eines Raman-Verlaufs, eines mit Stickstoff dotierten 4H-Siliziumcarbid-Festkörpers (Beispielspektrum für Raman an dotiertem SiC). Hierbei wird die Form der LO(PC)-Mode zur Messung der Dotierkonzentration herangezogen und gefittet. Unteres Panel: Fitting-Residual.

Fig. 6b zeigt einen kleineren Ausschnitt des Raman-Verlaufs.

Wie dargestellt ergibt sich eine direkte Methode, um mit Raman-Messungen die Dotandenkonzentration zu bestimmen aus einer Messung der Form und folgendem Fit an die LO(PC)-Mode.

Generell ist es somit das Ziel, durch Einstellen der Laserparameter den optimalen (kleinstmöglichen, kürzestmöglichen) Rissverlauf im Material einzustellen, der immer noch zu erfolgreichem Trennen infolge einer Rissausbreitung führt, jedoch anderweitig alle Materialverluste (auch in Schleifschritten) minimiert bzw. reduziert.

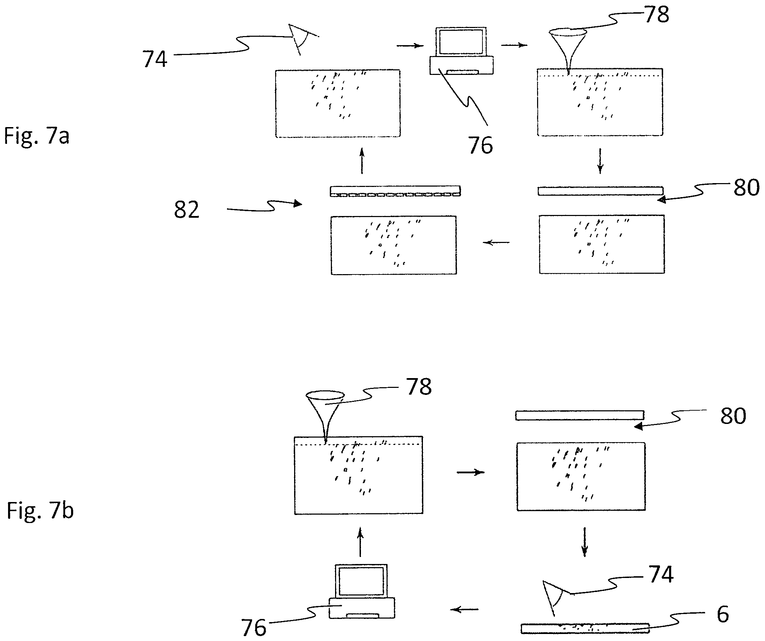

Fig. 7a und Fig. 7b zeigen zwei Möglichkeiten, das Abheben einzelner Wafer vom Boule/Ingot zu gestalten.

Gemäß Fig. 7a wird dies als Feedforward-Loop und gemäß Fig. 7b als Feedback-Loop ausgestaltet.

Beim Feedforward wird die Verteilung vor dem Laserprozess charakterisiert und daraus eine Karte bzw. Behandlungsanweisungen bzw. Parameteranpassungen, insbesondere ortsabhängig, für den Laserprozess, insbesondere die Modifikationserzeugung, berechnet. Feedforward wird bevorzugt am Ingot/Boule durchgeführt.

Alternativ kann, wie in Fig. 7b dargestellt, ein Feedback-Loop implementiert werden, gemäß dem nach jedem Trennschritt der entstandene Wafer charakterisiert wird und als Vorlage für den nächsten dient.

Je nach Material und Dotierung können somit unterschiedliche Anpassungen während des Laserprozesses vorgenommen werden:

Bei dem Material SiC können in unterschiedlichen Tiefen unterschiedliche Anpassungen der Laserparameter in Abhängigkeit von der auftretenden Dotierung vorgenommen werden. Dies kann bei den nachfolgend genannten Randbedingungen zu den ebenfalls nachfolgend genannten Funktionen führen:

Tiefe $180 \mu$m, Pulsdauer 3ns, numerische Apertur 0.4

| Niedrige Dotierung: | $7 \mu$J - 21mOhmcm |
|---|---|
| hohe Dotierung: | $8 \mu$J - 16mOhmcm |

Tiefe $350 \mu$m, Pulsdauer 3ns, numerische Apertur 0.4

| Niedrige Dotierung: | $9.5 \mu$J - 21mOhmcm |
|---|---|
| hohe Dotierung: | $12 \mu$J - 16mOhmcm |

Formel für $180 \mu$m Tiefe:

E     Energie in $\mu$J
E0    Offset-Energie bei niedrigster Dotierung
K     Faktor Energieskalierung
R     gemessener Dotiergrad
B     Basisdotiergrad (21mOhmcm)

$$E = E0+(B-R)*K$$

Hier

$$K = 1/(21-16) \, \mu\text{J/mOhmcm} = 0{,}2\mu\text{J/mOhmcm}$$

$$E0 = 7\mu\text{J}$$

$$B = 21\text{mOhmcm}$$

Beispiel: gemessener Dotiergrad von 19mOhmcm: $E = 7{,}4\mu$J

Formel für $350 \mu$m Tiefe:

E     Energie in $\mu$J

E0    Offset-Energie bei niedrigster Dotierung

K     Faktor Energieskalierung

R     gemessener Dotiergrad

B     Basisdotiergrad (21mOhmcm)

$$E = E0+(B-R)*K$$

Hier

$$K = 2,5/(21\text{-}16)\ \mu J/mOhmcm = 0,5\mu J/mOhmcm$$

E0 = 9,5$\mu$J

B = 21mOhmcm

Beispiel: gemessener Dotiergrad von 19mOhmcm: E = 10,5$\mu$J

Bezugszeichen liste

| | | | |
|---|---|---|---|
| 1 | Festkörper | 52 | Nutzer |
| 2 | Modifikation | 54 | Funktionsfluidquelle |
| 4 | Rissführungsbereich | 56 | Funktionsfluid |
| 6 | Festkörperanteil | 58 | Raman-Instrument |
| 8 | Laserbeaufschlagungseinrichtung | 60 | Laser |
| 10 | Laserstrahl | 61 | Optische Faser für Anregung |
| 12 | Datenspeichereinrichtung | 62 | Anregungsfilter |
| 14 | Steuerungseinrichtung | 64 | Linse |
| 16 | Sensoreinrichtung | 68 | Spektrograph |
| 18 | Aufnahmeeinrichtung | 70 | CCD-Detektor |
| 20 | Rotationsachse | 72 | Auswertungs- und/oder Aufbereitungseinrichtung oder Steuerungseinrichtung 14 |
| 22 | Antriebseinrichtung | | |
| 24 | Oberfläche des abzutrennenden Festkörperanteils | 74 | Inspektion |
| 26 | Aufnahmeschicht | 76 | Anpassung Laserparameter und/oder Maschinenparameter und Erzeugung von ortsaufgelösten Behandlungsanweisungen bzw. eine ortsaufgelösten Behandlungskarte |
| 30 | Vorrichtung | | |
| 32 | Laserstrahlenquelle | | |
| 34 | Kamera | | |
| 36 | Optisches Element | | |
| 38 | Strahlteiler | 78 | Laserprozess (Erzeugen von Modifikationen) |
| 40 | sphärisches Aberrationkompensationsmittel | 80 | Abtrennschritt, insbesondere mittels Rissauslösung und Rissführung |
| 42 | Beamexpander | | |
| 44 | Einstelleinrichtung | 82 | Oberflächenbehandlung |
| 46 | Mikroskop mit langem Arbeitsabstand | | |
| 48 | Fluidquelle | | |
| 50 | Brechzahlbestimmungsmittel | | |

## Patentansprüche

1. Verfahren zur Erzeugung von Modifikationen in einem Festkörper (1), wobei durch die Modifikationen (2) ein Rissführungsbereich (4) zum Führen eines Risses zum Abtrennen eines Festkörperanteils (6), insbesondere einer Festkörperschicht, von dem Festkörper (1) vorgegeben wird, mindestens umfassend die Schritte:

   Bewegen des Festkörpers (1) relativ zu einer Laserbeaufschlagungseinrichtung (8), aufeinanderfolgendes Emittieren von einer Vielzahl an Laserstrahlen (10) mittels der Laserbeaufschlagungseinrichtung (8) zum Erzeugen von jeweils mindestens einer Modifikation (2) innerhalb des Festkörpers (1),
**dadurch gekennzeichnet, dass**
die Laserbeaufschlagungseinrichtung (8) zur definierten Fokussierung der Laserstrahlen (10) und/oder zur Anpassung der Laserenergie kontinuierlich in Abhängigkeit von mindestens zwei Parametern eingestellt wird, wobei ein Parameter der Grad der Dotierung des Festkörpers an einem vorbestimmten Ort oder in einem vorbestimmten Bereich, insbesondere im Inneren, des Festkörpers, insbesondere beabstandet zur Festkörperoberfläche, ist.

**2.** Verfahren nach Anspruch 1,
**dadurch gekennzeichnet, dass** der Grad der Dotierung des Festkörpers (1) als zusätzlicher Parameter definiert wird, und ein erster Parameter die mittlere Brechzahl des Materials des Festkörpers (1) oder die Brechzahl des Materials des Festkörpers (1) in dem Bereich des Festkörpers (1) ist, der zur Erzeugung einer definierten Modifikation (2) von Laserstrahlen (10) zu durchqueren ist und ein zweiter Parameter die Bearbeitungstiefe in dem Bereich des Festkörpers (1) ist, der zur Erzeugung einer definierten Modifikation (2) von Laserstrahlen (10) zu durchqueren ist.

**3.** Verfahren nach Anspruch 2,
**dadurch gekennzeichnet, dass**
der erste Parameter mittels eines Brechzahlbestimmungsmittels, insbesondere mittels spektraler Reflektion, bestimmt wird und/oder
der zweite Parameter mittels eines Topografiebestimmungsmittels, insbesondere mittels eines konfokal-chromatischen Distanzsensors, bestimmt wird.

**4.** Verfahren nach einem der Ansprüche 1 bis 3,
**dadurch gekennzeichnet, dass** Daten zu den Parametern in einer Datenspeichereinrichtung (12) bereitgestellt werden und zumindest vor der Erzeugung der Modifikationen (2) einer Steuerungseinrichtung (14) zugeführt werden, wobei die Steuerungseinrichtung (14) die Laserbeaufschlagungseinrichtung (8) in Abhängigkeit vom jeweiligen Ort der zu erzeugenden Modifikation (2) einstellt.

**5.** Verfahren nach Anspruch 4,
**dadurch gekennzeichnet, dass**
die Steuerungseinrichtung (14) zur Einstellung der Laserbeaufschlagungseinrichtung (8) ebenfalls Distanzdaten zu einem Distanzparameter verarbeitet, wobei der Distanzparameter den Abstand des jeweiligen Ortes, an dem Laserstrahlen (10) zur Erzeugung der jeweiligen Modifikation (2) in den Festkörper (1) zum Zeitpunkt der Modifikationserzeugung eingeleitet werden, gegenüber der Laserbeaufschlagungseinrichtung (8) wiedergibt, wobei die Distanzdaten mittels einer Sensoreinrichtung (16) erfasst werden.

**6.** Verfahren nach einem der Ansprüche 2 bis 3,
**dadurch gekennzeichnet, dass**
die Einstellung der Laserbeaufschlagungseinrichtung (8) in Abhängigkeit von einer während der Modifikationserzeugung erfolgenden Bestimmung des ersten Parameters und des zweiten Parameters mittels jeweils eines Sensormittels, insbesondere einem Brechzahlbestimmungsmittel und einem Topografiebestimmungsmittel, erfolgt.

**7.** Verfahren nach Anspruch 1,
**dadurch gekennzeichnet, dass**
der Grad der Dotierung durch die Analyse von zurückgestreutem Licht mit einer unelastischen Streuung (Raman-Streuung) bestimmt wird, wobei das zurückgestreute Licht eine andere Wellenlänge oder einen anderen Wellenlängenbereich aufweist als zum Auslösen der Zurückstreuung definiert eingestrahltes Licht, wobei das zurückgestreute Licht von dem vordefinierten Ort aus oder von dem vorbestimmten Bereich aus zurückgestreut wird.

**8.** Verfahren nach Anspruch 1,
**dadurch gekennzeichnet, dass**
der Grad der Dotierung mittels einer Wirbelstrommessung bestimmt wird, wobei Leitfähigkeitsunterschiede im Festkörpermaterial bestimmt werden.

**9.** Verfahren zum Abtrennen von mindestens einem Festkörperanteil, insbesondere Festkörperschicht, von einem Festkörper (1),
mindestens umfassend

ein Verfahren gemäß einem der Ansprüche 1 bis 8,
ferner umfassend die Erzeugung von so vielen Modifikationen (2) in dem Festkörper (1), dass sich der Festkörperanteil infolge der Modifikationserzeugung ablöst
oder
das Anordnen oder Erzeugen einer Aufnahmeschicht (26) an dem Festkörper (1), wobei die Aufnahmeschicht (26) ein Polymermaterial, insbesondere Polydimethylsiloxan (PDMS) oder ein Elastomer oder ein Epoxidharz oder eine Kombination daraus, aufweist oder daraus besteht, und das Polymermaterial infolge einer thermischen Beaufschlagung der Aufnahmeschicht (26) zum, insbesondere mechanischen, Erzeugen von Rissausbreitungsspannungen in dem Festkörper (1) einen Glasübergang erfährt, wobei sich durch die Rissausbreitungsspannungen ein Riss in dem Festkörper (1) entlang dem Rissführungsbereich (4) ausbreitet.

10. Verfahren nach Anspruch 9,
**dadurch gekennzeichnet, dass**
die Aufnahmeschicht (140) massemäßig zumindest mehrheitlich und bevorzugt vollständig aus dem Polymermaterial besteht, wobei der Glasübergang des Polymermaterials zwischen -100°C und 0°C, insbesondere zwischen -85°C und -10°C oder zwischen -80°C und -20°C oder zwischen -65°C und -40°C oder zwischen -60°C und -50°C, liegt, wobei die Aufnahmeschicht (140) bevorzugt aus einem Polymer-Hybrid-Material besteht, das eine Polymermatrix ausbildet, wobei sich in der Polymermatrix ein Füllstoff befindet, wobei die Polymermatrix bevorzugt eine Polydimethylsiloxan-Matrix ist und wobei der Masseanteil der Polymermatrix am Polymer-Hybrid-Material bevorzugt 80 % bis 99 % und besonders bevorzugt 90 % bis 99 % beträgt.

11. Vorrichtung (30) zum Erzeugen von Modifikationen (2) in einem Festkörper (1), wobei durch die Modifikationen (2) ein Rissführungsbereich (4) zum Führen eines Risses zum Abtrennen eines Festkörperanteils, insbesondere einer Festkörperschicht, von dem Festkörper (1) vorgegeben wird,
mindestens umfassend:

eine Aufnahmeeinrichtung (18) zum Aufnehmen und Bewegen von mindestens einem Festkörper (1),
eine Laserbeaufschlagungseinrichtung (8) zum Emittieren von einer Vielzahl an aufeinanderfolgenden Laserstrahlen (10), wobei die Laserstrahlen (10) fokussiert werden und in dem Fokuspunkt eine Modifikation (2) innerhalb des Festkörpers (1) erzeugen,
**gekennzeichnet durch**:

eine Steuerungseinrichtung (14), wobei die Steuerungseinrichtung (14) Daten mindestens zu einem ersten Parameter und zu einem zweiten Parameter, die in Echtzeit durch entsprechende und damit kommunizierend verbundene Sensoreinrichtungen empfängt, oder in Form entsprechender ortsabhängiger Daten in einer Speichereinrichtung vorgehalten werden, verarbeitet und in Abhängigkeit dieser Daten die Fokussierung und/oder Laserenergie der Laserbeaufschlagungseinrichtung (8) kontinuierlich, insbesondere für jede Modifikation (2), einstellt,
wobei ein Parameter der Grad der Dotierung des Festkörpers an einem vorbestimmten Ort oder in einem vorbestimmten Bereich, insbesondere im Inneren, des Festkörpers, insbesondere beabstandet zur Festkörperoberfläche, ist.

12. Vorrichtung nach Anspruch 11,
**dadurch gekennzeichnet, dass** der Grad der Dotierung des Festkörpers (1) als zusätzlicher Parameter definiert wird,
und ein erster Parameter die mittlere Brechzahl des Materials des Festkörpers (1) oder die Brechzahl des Materials des Festkörpers (1) in dem Bereich des Festkörpers (1) ist, der zur Erzeugung einer definierten Modifikation (2) von Laserstrahlen (10) zu durchqueren ist und ein zweiter Parameter die Bearbeitungstiefe in dem Bereich des Festkörpers (1) ist, der zur Erzeugung einer definierten Modifikation (2) von Laserstrahlen (10) zu durchqueren ist,
wobei der Grad der Dotierung des Festkörpermaterials durch die Analyse von zurückgestreutem Licht bestimmt wird, wobei das zurückgestreute Licht eine andere Wellenlänge oder einen anderen Wellenlängenbereich aufweist als zum Auslösen der Zurückstreuung definiert eingestrahltes Licht, wobei ein Raman-Instrument Bestandteil der Vorrichtung ist und der Grad der Dotierung mittels des Raman-Instruments bestimmt wird
wobei ein oder mehrere oder alle dieser Parameter bevorzugt mittels eines gemeinsamen Detektionskopfes, insbesondere zeitgleich, erfasst werden.

13. Vorrichtung nach Anspruch 11 oder 12,
**dadurch gekennzeichnet, dass**

eine Distanzsensoreinrichtung (16) zur Bestimmung eines Verkippungsparameters vorgesehen ist, wobei der Verkippungsparameter eine Verkippung des Festkörpers (1) gegenüber der Laserbeaufschlagungseinrichtung repräsentiert, wobei die Distanzsensoreinrichtung (16) Distanzdaten ausgibt, und wobei die Distanzdaten ebenfalls von der Steuerungseinrichtung (14) zum Einstellen der Laserbeaufschlagungseinrichtung (8) verarbeitet werden.

**14.** Vorrichtung nach einem der Ansprüche 11 bis 12,
**dadurch gekennzeichnet, dass**
eine Antriebseinrichtung (22) zum Bewegen der Aufnahmeeinrichtung (8) vorgesehen ist, wobei die Steuerungseinrichtung (14) die Bewegungsgeschwindigkeit der Aufnahmeeinrichtung (8) und/oder den Laserfokus und/oder die Laserenergie in Abhängigkeit von den verarbeiteten Parametern in einem Feedforwardprozess einstellt.

**Claims**

**1.** Method for producing modifications in a solid body (1), wherein a crack guidance region (4) for guiding a crack for separating a solid-body portion (6), in particular a solid-body layer, from the solid body (1) is specified by the modifications (2),

comprising at least the steps of:

moving the solid body (1) relative to a laser impingement device (8),
successively emitting a multiplicity of laser beams (10) by means of the laser impingement device (8) for producing in each case at least one modification (2) within the solid body (1),
**characterized in that**
the laser impingement device (8) is set for defined focusing of the laser beams (10) and/or for continuously adapting the laser energy in dependence on at least two parameters,
wherein one parameter is the degree of doping of the solid body at a predetermined location or in a predetermined region, in particular in the interior, of the solid body, in particular at a distance from the solid-body surface.

**2.** Method according to Claim 1,
**characterized in that**
the degree of doping of the solid body (1) is defined as an additional parameter,
and a first parameter is the average refractive index of the material of the solid body (1) or the refractive index of the material of the solid body (1) in the region of the solid body (1) that laser beams (10) must traverse to produce a defined modification (2) and
a second parameter is the processing depth in the region of the solid body (1) that laser beams (10) must traverse to produce a defined modification (2).

**3.** Method according to Claim 2,
**characterized in that**
the first parameter is determined using a refractive index determination means, in particular using spectral reflection, and/or
the second parameter is determined using a topography determination means, in particular using a confocal chromatic distance sensor.

**4.** Method according to one of Claims 1 to 3,
**characterized in that**
data relating to the parameters are provided in a data storage device (12) and are supplied to a control device (14) at least before the modifications (2) are produced, wherein the control device (14) sets the laser impingement device (8) in dependence on the respective location of the modification (2) that is to be produced.

**5.** Method according to Claim 4,
**characterized in that**
the control device (14) likewise processes distance data to obtain a distance parameter for setting the laser impingement device (8), wherein the distance parameter represents the distance of the respective location at which laser beams (10) are introduced into the solid body (1) at the time of the modification production to produce the respective modification (2) from the laser impingement device (8), wherein the distance data are captured using a sensor device (16).

**6.** Method according to one of Claims 2 to 3,
**characterized in that**
the laser impingement device (8) is set in dependence on a determination of the first parameter and of the second parameter, carried out during the modification production, using in each case a sensor means, in particular a refractive index determination means and a topography determination means.

**7.** Method according to Claim 1,
**characterized in that**
the degree of doping is determined by the analysis of back-scattered light with inelastic scattering (Raman scattering), wherein the back-scattered light has a different wavelength or a different wavelength range than light that is radiated in in a defined manner in order to trigger the back-scattering, wherein the back-scattered light is scattered back from the predefined location or from the predetermined region.

**8.** Method according to Claim 1,
**characterized in that**
the degree of doping is determined using an eddy current measurement, wherein conductivity differences in the solid=body material are determined.

**9.** Method for separating at least one solid-body portion, in particular solid-body layer, from a solid body (1),
at least comprising
a method according to one of Claims 1 to 8,
further comprising
producing a sufficient number of modifications (2) in the solid body (1) for the solid-body portion to detach following the modification production or
arranging or producing a receiving layer (26) at the solid body (1), wherein the receiving layer (26) has or consists of a polymer material, in particular polydimethylsiloxane (PDMS) or an elastomer or an epoxy resin or a combination thereof, and the polymer material experiences a glass transition following an application of heat to the receiving layer (26) for producing, in particular mechanically, crack propagation stresses in the solid body (1), wherein a crack propagates in the solid body (1) along the crack guidance region (4) due to the crack propagation stresses.

**10.** Method according to Claim 9,
**characterized in that**
the receiving layer (140) consists in terms of mass at least primarily and preferably completely of the polymer material, wherein the glass transition of the polymer material is between -100°C and 0°C, in particular between -85°C and -10°C or between -80°C and -20°C or between -65°C and -40°C or between -60°C and -50°C, wherein the receiving layer (140) preferably consists of a polymer hybrid material that forms a polymer matrix, wherein a filler is located in the polymer matrix, wherein the polymer matrix is preferably a polydimethylsiloxane matrix and wherein the percentage by mass of the polymer matrix in the polymer hybrid material is preferably 80% to 99% and, with particular preference, 90% to 99%.

**11.** Apparatus (30) for producing modifications (2) in a solid body (1), wherein a crack guidance region (4) for guiding a crack for separating a solid-body portion, in particular a solid-body layer, from the solid body (1) is specified by the modifications (2),
at least comprising:

a receiving device (18) for receiving and moving at least one solid body (1),
a laser impingement device (8) for emitting a multiplicity of successive laser beams (10), wherein the laser beams (10) are focused and produce a modification (2) inside the solid body (1) in the focal point,
**characterized by**
a control device (14), wherein the control device (14) processes data at least relating to a first parameter and to a second parameter that are received in real time by corresponding, and thus communicatively connected, storage devices or are stored in a storage device in the form of corresponding spatially dependent data and sets the focusing and/or laser energy of the laser impingement device (8) continuously, in particular for each modification (2), in dependence on said data,
wherein one parameter is the degree of doping of the solid body at a predetermined location or in a predetermined region, in particular in the interior, of the solid body, in particular at a distance from the solid-body surface.

**12.** Apparatus according to Claim 11,

**characterized in that**

the degree of doping of the solid body (1) is defined as an additional parameter,

and a first parameter is the average refractive index of the material of the solid body (1) or the refractive index of the material of the solid body (1) in the region of the solid body (1) that laser beams (10) must traverse to produce a defined modification (2) and

a second parameter is the processing depth in the region of the solid body (1) that laser beams (10) must traverse to produce a defined modification (2),

wherein the degree of doping of the solid-body material is determined by the analysis of back-scattered light,

wherein the back-scattered light has a different wavelength or a different wavelength range than light that is radiated in in a defined manner in order to trigger the back-scattering, wherein a Raman instrument is a constituent part of the apparatus and the degree of doping is determined using the Raman instrument,

wherein one or more or all of these parameters are captured, in particular simultaneously, preferably using a common detection head.

**13.** Apparatus according to Claim 11 or 12,
**characterized in that**
a distance sensor device (16) is provided for determining a tilt parameter, wherein the tilt parameter represents a tilt of the solid body (1) relative to the laser impingement device, wherein the distance sensor device (16) outputs distance data, and wherein the distance data are likewise processed by the control device (14) for setting the laser impingement device (8).

**14.** Apparatus according to one of Claims 11 to 12,
**characterized in that**
a drive device (22) for moving the receiving device (8) is provided, wherein the control device (14) sets the movement speed of the receiving device (8) and/or the laser focus and/or the laser energy in dependence on the processed parameters in a feed-forwarding process.

**Revendications**

**1.** Procédé de production de modifications dans un semi-conducteur (1), dans lequel par les modifications (2) on prescrit une région (4) de guidage de fissure pour guider une fissure en vue de séparer du semi-conducteur (1) une partie (6) du semi-conducteur, notamment une couche du semi-conducteur,
comprenant au moins les stades :

déplacement du semi-conducteur (1) par rapport à un dispositif (8) d'alimentation laser,
émission successive d'une pluralité de faisceaux (10) laser au moyen du dispositif (8) d'alimentation laser pour la production de respectivement au moins une modification (2) au sein du semi-conducteur (1),
**caractérisé en ce que**
on règle le dispositif (8) d'alimentation laser pour la focalisation définie des faisceaux (10) laser et/ou l'adaptation de l'énergie laser, d'une manière continue en fonction d'au moins deux paramètres,
dans lequel un paramètre est le degré de dopage du semi-conducteur en un emplacement déterminé à l'avance ou dans une région déterminée à l'avance, notamment à l'intérieur, du semi-conducteur, notamment à distance de la surface du semi-conducteur.

**2.** Procédé suivant la revendication 1,
**caractérisé en ce que**
on définit le degré de dopage du semi-conducteur (1) comme paramètre supplémentaire et un premier paramètre est l'indice de réfraction moyen du matériau du semi-conducteur (1) ou l'indice de réfraction du matériau du semi-conducteur (1) dans la région du semi-conducteur (1), qui est traversée par des faisceaux (10) lasers pour la production d'une modification (2) définie, et un deuxième paramètre est la profondeur d'usinage dans la région du semi-conducteur (1), qui est traversée par des faisceaux (10) lasers pour la production d'une modification (2) définie.

**3.** Procédé suivant la revendication 2,
**caractérisé en ce que**
on détermine le premier paramètre au moyen d'un moyen de détermination de l'indice de réfraction, notamment au moyen d'une réfraction spectrale et/ou
on détermine le deuxième paramètre au moyen d'un moyen de détermination de la topographie, notamment au moyen d'un capteur de distance chromatique confocal.

4. Procédé suivant l'une des revendication 1 à 3,
   **caractérisé en ce que**
   on se procure des données sur les paramètres dans un dispositif (12) de mise en mémoire de données et on les envoie à un dispositif (14) de commande au moins avant la production des modifications (2), le dispositif (14) de commande réglant le dispositif (8) d'alimentation laser en fonction de l'emplacement respectif de la modification (2) à produire.

5. Procédé suivant la revendication 4,
   **caractérisé en ce que**
   le dispositif (14) de commande transforme pour régler le dispositif (8) d'alimentation laser également des données de distance en un paramètre de distance, le paramètre de distance reproduisant par rapport au dispositif (8) d'alimentation laser la distance de l'emplacement respectif, où des faisceaux (10) laser sont, à l'instant de la production de la modification, envoyés dans le semi-conducteur (1) pour la production de la modification (2) respective, les données de distance étant relevées au moyen d'un dispositif (16) de capteur.

6. Procédé suivant l'une des revendications 2 à 3,
   **caractérisé en ce que**
   le réglage du dispositif (8) d'alimentation laser s'effectue en fonction d'une détermination, s'effectuant pendant la production de la modification, du premier paramètre et du deuxième paramètre au moyen de respectivement un moyen de capteur, notamment un moyen de détermination de l'indice de réfraction et un moyen de détermination de la topographie.

7. Procédé suivant la revendication 1,
   **caractérisé en ce que**
   on détermine le degré de dopage par l'analyse de la lumière rétrodiffusée avec une diffusion inélastique (diffusion Raman), la lumière rétrodiffusée ayant une longueur d'onde ou un domaine de longueur d'onde autre que la lumière incidente, de manière définie, pour le déclenchement de la rétrodiffusion, la lumière rétrodiffusée étant rétrodiffusée de l'emplacement défini à l'avance ou de la région déterminée à l'avance.

8. Procédé suivant la revendication 1,
   **caractérisé en ce que**
   l'on détermine le degré de dopage au moyen d'une mesure de courant de Foucault, dans lequel on détermine des différences de conductivité dans le matériau du semi-conducteur.

9. Procédé de séparation d'au moins une partie de semi-conducteur, notamment d'une couche de semi-conducteur, d'un semi-conducteur (1)
   comprenant au moins
   un procédé suivant l'une des revendications 1 à 8,
   comprenant en outre
   la production de tant de modifications (2) dans le semi-conducteur (1) que la partie de semi-conducteur se détache en raison de la production des modifications
   ou
   la mise ou la production d'une couche (26) d'absorption sur le semi-conducteur (1), la couche (26) d'absorption ayant une matière polymère, notamment du polydiméthylsiloxane (PDMS) ou un élastomère ou une résine époxyde ou l'une de leurs combinaisons ou en étant constituée, et la matière polymère subissant, en raison d'une contrainte thermique de la couche (28) d'absorption pour la production, notamment mécanique, de tensions de propagation de fissure dans le semi-conducteur (1), une transition à l'état vitreux, une fissure dans le semi-conducteur (1) se propageant par les tensions de propagation de fissure le long de la région (4) de guidage de la fissure.

10. Procédé suivant la revendication 9,
    **caractérisé en ce que**
    la couche (140) d'absorption est constituée en masse au moins majoritairement et, de préférence entièrement, en la matière polymère, le point de transition à l'état vitreux de la matière polymère étant compris entre -100°C et 0°C, notamment entre -85°C et -10°C ou entre -80°C et -20°C ou entre -65°C et -40°C ou entre -60°C et -50°C, dans lequel la couche (140) d'absorption est de préférence en une matière polymère-hybride, qui constitue une matrice polymère, une charge se trouvant dans la matrice polymère, la matrice polymère étant de préférence une matrice de polydiméthylsiloxane et la proportion en masse de matière polymère-hybride dans la matrice polymère représentant de préférence de 80% à 99% et, d'une manière particulièrement préférée, de 90% à 99%.

**11.** Installation (30) de production de modifications (2) dans un semi-conducteur (1), dans laquelle par les modifications (2) on prescrit une région de guidage de fissure pour guider une fissure en vue de séparer du semi-conducteur (1) une partie (6) de semi-conducteur, notamment une couche de semi-conducteur, comprenant au moins :

un dispositif (18) de réception pour la réception et le déplacement d'au moins un semi-conducteur (1), un dispositif (8) d'alimentation laser pour l'émission d'une pluralité de faisceaux (10) laser successifs, les faisceaux (10) laser étant focalisés et produisant au point focal une modification (2) au sein du semi-conducteur (1), **caractérisée par** :

un dispositif (14) de commande, le dispositif (14) de commande transformant des données au moins en un premier paramètre et en un deuxième paramètre, qu'il reçoit en temps réel par des dispositifs capteurs adéquats et communiquant entre eux ou qui sont mis en réserve sous la forme de données correspondantes en fonction de l'emplacement, dans un dispositif de mise en mémoire, et réglant, en fonction de ces données, la focalisation et/ou l'énergie laser du dispositif (8) d'alimentation laser en continu, notamment pour chaque modification (2),
dans laquelle un paramètre est le degré de dopage du semi-conducteur en un emplacement déterminé à l'avance ou dans une région déterminée à l'avance, notamment à l'intérieur, du semi-conducteur, notamment à distance de la surface du semi-conducteur.

**12.** Installation suivant la revendication 11,
**caractérisée en ce que**
on définit le degré de dopage du semi-conducteur (1) comme paramètre supplémentaire et un premier paramètre est l'indice de réfraction moyen du matériau du semi-conducteur (1) ou l'indice de réfraction du matériau du semi-conducteur (1) dans la région du semi-conducteur (1), qui est traversée par des faisceaux (10) laser pour la production d'une modification (2) définie et un deuxième paramètre est la profondeur d'usinage dans la région du semi-conducteur (1), qui est traversée par des faisceaux (10) laser pour la production d'une modification (2) définie,
dans laquelle on détermine le degré de dopage par l'analyse de la lumière rétrodiffusée avec une diffusion inélastique (diffusion Raman), la lumière rétrodiffusée ayant une longueur d'onde ou un domaine de longueur d'onde autre que la lumière incidente, de manière définie, pour le déclenchement de la rétrodiffusion, l'instrument Raman étant une partie constitutive de l'installation et on détermine le degré de dopage au moyen de l'instrument Raman,
dans lequel on relève, notamment en même temps, un ou plusieurs ou tous ces paramètres, de préférence au moyen d'une tête de détection commune.

**13.** Installation suivant la revendication 11 ou 12,
**caractérisée en ce que**
il est prévu un dispositif (16) de capteur de distance pour la détermination d'un paramètre de basculement, le paramètre de basculement représentant un basculement du semi-conducteur (1) par rapport au dispositif d'alimentation laser, le dispositif (16) capteur de distance donnant des données de distance, et dans laquelle les données de distance sont transformées également par le dispositif (14) de commande pour régler le dispositif (8) d'alimentation laser.

**14.** Installation suivant l'une des revendications 11 à 12,
**caractérisée en ce que**
il est prévu un dispositif (22) d'entraînement pour le déplacement du dispositif (8) de réception, le dispositif (14) de commande réglant suivant un processus feedforward la vitesse de déplacement du dispositif (8) de réception et/ou le foyer laser et/ou l'énergie laser en fonction des paramètres transformés.

EP 3 400 110 B1

Fig. 1

Fig. 2a

Fig. 2b

Fig. 3b

Fig. 3a

Fig. 4b

Fig. 4a

Fig. 5a

Fig. 5b

A1          E1          E2

EP 3 400 110 B1

Fig. 6a

Fig. 6b

Fig. 7a

Fig. 7b

**IN DER BESCHREIBUNG AUFGEFÜHRTE DOKUMENTE**

**In der Beschreibung aufgeführte Patentdokumente**

- EP 1338371 A1

- WO 2010072675 A